# EUROPEAN PATENT APPLICATION

(11) **EP 4 657 413 A1**
(43) Date of publication of application: **03.12.2025**
(21) Application number: 24884224.7
(22) Date of filing: 02.09.2024
(51) Int. Cl.: G09F 9/30

(54) **DISPLAY MODULE, PREPARATION METHOD FOR DISPLAY MODULE, AND DISPLAY DEVICE**

(30) Priority: 30.10.2023 CN 202311423893
(71) Applicant: Boe Technology Group Co., Ltd., Beijing 100015 (CN); Chengdu BOE Optoelectronics Technology Co., Ltd., Chengdu, Sichuan 611731 (CN)
(72) Inventor: LUO, Liang, Beijing 100176 (CN); ZHAI, Jianpeng, Beijing 100176 (CN); SHI, Jiafan, Beijing 100176 (CN); WANG, Yangpeng, Beijing 100176 (CN); ZHOU, Guodong, Beijing 100176 (CN); CHEN, Liqiang, Beijing 100176 (CN); YIN, Qian, Beijing 100176 (CN)
(74) Representative: Hoffmann Eitle
(86) International application number: PCT/CN2024/116382
(87) International publication number: WO 2025/092217

(57) **Abstract**

A display module (100'), a preparation method for the display module (100'), and a display device (1000'). The display module (100') comprises a display panel (10), a cover plate (30), and a first frame (21). The cover plate (30) is stacked on a display side of a display portion (11). The first frame (21) is arranged on the side of the cover plate (10) close to the display panel (10) and extends along a side edge of the cover plate (30) corresponding to a binding portion (13). The first frame (21) comprises a first retaining wall (211), a second retaining wall (212), and a first filling portion (213). One end of the first retaining wall (211) is connected to an edge area of the cover plate (30), one end of the second retaining wall (212) is connected to the binding portion (13), and there is a gap between the first retaining wall (211) and the second retaining wall (212). The first filling portion (213) is filled between the first retaining wall (211) and the second retaining wall (212). The viscosity of a material used for forming the first retaining wall (211) and the second retaining wall (212) is greater than the viscosity of a material used for forming the first filling portion (213). The display module (100') is used for displaying an image.

## Description

This application claims priority to Chinese Patent Application No. 202311423893.6, filed on October 30, 2023, which is incorporated herein by reference in its entirety.

### TECHNICAL FIELD

The present disclosure relates to the field of display technologies, and in particular, to a display module, a method for manufacturing a display module, and a display apparatus.

### BACKGROUND

With the continuous development of display technology, display apparatuses have gradually spread in people's lives. Among them, organic light-emitting diode (OLED) display panels are widely used in smart products such as mobile phones, televisions, and notebook computers owning the advantages of self-luminescence, low power consumption, wide viewing angle, fast response speed, and high contrast ratio. The implementation of narrow frame is an important development direction for display apparatuses at present.

### SUMMARY

In an aspect, a display module is provided. The display module includes a display panel, a cover plate and a first frame. The display panel includes a display portion, a bending portion and a bonding portion that are connected to each other in sequence, where the bending portion is bent to enable the bonding portion to be located on a non-display side of the display portion. The cover plate is provided on a display side of the display portion in a stack, where a boundary of the cover plate is farther away from the display portion than a boundary of the bending portion farthest from the display portion. The first frame is provided on a side of the cover plate proximate to the display panel and extends along a side edge of the cover plate corresponding to the bonding portion.

The first frame includes a first retaining wall, a second retaining wall and a first filling portion. An end of the first retaining wall is connected to an edge region of the cover plate, an end of the second retaining wall is connected to the bonding portion, and the first retaining wall and the second retaining wall have a spacing therebetween. The first filling portion is provided between the first retaining wall and the second retaining wall in a filling manner. A viscosity of a material for forming the first retaining wall and a viscosity of a material for forming the second retaining wall are greater than a viscosity of a material for forming the first filling portion.

In some embodiments, the display module further includes a top cover. The top cover is connected to ends, away from the cover plate, of the first retaining wall and the second retaining wall. The top cover, the first retaining wall and the second retaining wall form an accommodation space enclosed thereby, and the accommodation space is filled with the first filling portion. The top cover is provided therein with a plurality of through holes.

In some embodiments, the top cover includes a support layer and a body layer that are arranged in a stack, the support layer being closer to the cover plate than the body layer.

In some embodiments, the support layer includes a metal mesh, and edges of the body layer are connected to the first retaining wall and the second retaining wall through mesh holes of the metal mesh.

In some embodiments, a material of the body layer is the same as the material of the first retaining wall.

In some embodiments, a width of a portion of the top cover provided with the through holes is greater than a width of a portion not provided with the through holes.

In some embodiments, the ends, away from the cover plate, of the first retaining wall and the second retaining wall are each provided with a notch, and edges of the top cover are placed within notches of the first retaining wall and the second retaining wall.

In some embodiments, the first filling portion is provided therein with magnetic particles or conductive particles.

In some embodiments, the magnetic particles include at least one type of magnetic nanoparticles or magnetic polymer particles; and the conductive particles include at least one type of organic conductive particles or carbon conductive particles.

In some embodiments, the display module further includes an ink layer provided on the side of the cover plate proximate to the display panel and located on the edge region of the cover plate. The first filling portion is in contact with the ink layer, and a portion of the first filling portion extends between the bending portion and the ink layer.

In some embodiments, the ink layer has magnetism.

In some embodiments, the bending portion is bent to form a cavity facing the display portion; and the display module further includes a third filling portion provided in the cavity formed by the bending portion in a filling manner, a material of the third filling portion being different from the material of the first filling portion.

In some embodiments, the display module further includes a second frame, where the first frame is connected to the second frame to form a box-frame surrounding the display panel. A width of the second frame is substantially equal to a width of the first retaining wall or the second retaining wall, and a viscosity of a material for forming the second frame is greater than the viscosity of the material for forming the first filling portion.

In some embodiments, a width of the first frame is greater than the width of the second frame.

In some embodiments, the display module further includes a second frame, where the first frame is connected to the second frame to form a box-frame surrounding the display panel. The second frame includes a third retaining wall, a fourth retaining wall and a second filling portion. An end of the third retaining wall is connected to the edge region of the cover plate, an end of the fourth retaining wall is connected to the display portion, and the third retaining wall and the fourth retaining wall have a spacing therebetween. The second filling portion is provided between the third retaining wall and the fourth retaining wall in a filling manner. A viscosity of a material for forming the third retaining wall and a viscosity of a material for forming the fourth retaining wall are greater than a viscosity of a material for forming the second filling portion.

In some embodiments, the display module includes a top cover, the top cover being connected to ends, away from the cover plate, of the first retaining wall, the second retaining wall, the third retaining wall, and the fourth retaining wall. The top cover, the first retaining wall, the second retaining wall, the third retaining wall, and the fourth retaining wall form an accommodation space enclosed thereby, and the accommodation space is filled with the first filling portion and the second filling portion. The top cover is provided therein with a plurality of through holes.

In some embodiments, the display module further includes at least one fifth retaining wall, the fifth retaining wall being provided in the accommodation space to divide the accommodation space into a plurality of accommodation sub-spaces. A region, corresponding to each of the accommodation sub-spaces, of the top cover is provided therein with multiple ones of the plurality of through holes.

In some embodiments, the first retaining wall, the second retaining wall and the first filling portion are formed as a one-piece structure, and a surface of the first filling portion away from the cover plate is recessed in a direction proximate to the cover plate.

In some embodiments, the first retaining wall, the second retaining wall, the first filling portion, and the body layer of the top cover are formed as a one-piece structure, and the support layer of the top cover is embedded in the one-piece structure.

In another aspect, a method for manufacturing a display module is provided. The method for manufacturing the display module includes: providing a display panel, the display panel including a display portion, a bending portion and a bonding portion that are connected to each other in sequence, and bending the bending portion to enable the bonding portion to be located on a non-display side of the display portion; providing a cover plate on a display side of the display portion in a stack, where a boundary of the cover plate is farther away from the display portion than a boundary of the bending portion farthest from the display portion; and forming a first frame on a side of the cover plate proximate to the display panel, the first frame extending along a side edge of the cover plate corresponding to the bonding portion.

Forming the first frame includes: forming a first retaining wall on an edge region of the cover plate by a printing process; forming a second retaining wall on a side of the bonding portion away from the cover plate by a printing process, the second retaining wall and the first retaining wall having a spacing therebetween; and forming a first filling portion between the first retaining wall and the second retaining wall by a printing process or an adhesive pouring process; where a viscosity of a material for forming the first retaining wall and a viscosity of a material for forming the second retaining wall are greater than a viscosity of a material for forming the first filling portion.

In some embodiments, the method for manufacturing the display module further includes: forming a top cover, the top cover being connected to ends, away from the cover plate, of the first retaining wall and the second retaining wall, to enable the top cover, the first retaining wall and the second retaining wall to form an accommodation space enclosed thereby, where the top cover is provided therein with a plurality of through holes, and the plurality of through holes include at least one pouring hole and at least one exhaust hole; and injecting an adhesive material into the accommodation space through the pouring hole by an adhesive pouring process, and evacuating the accommodation space through the exhaust hole to enable the adhesive material to fill the accommodation space to form the first filling portion.

In some embodiments, forming the top cover includes: forming a support layer on the ends, away from the cover plate, of the first retaining wall and the second retaining wall; and forming a body layer on a side of the support layer away from the cover plate by a printing process.

In some embodiments, forming the first filling portion includes: putting an adhesive material containing conductive particles or magnetic particles between the first retaining wall and the second retaining wall; and applying an electric field force or a magnetic field force to the display module to enable the adhesive material containing the conductive particles or the magnetic particles to flow toward a side proximate to the cover plate, and flow to a space between the cover plate and the bending portion.

In some embodiments, forming the first filling portion includes: forming a magnetic ink layer on the edge region of the cover plate on a side thereof proximate to the display panel; and putting an adhesive material containing magnetic particles between the first retaining wall and the second retaining wall, to enable the magnetic particles within the adhesive material containing the magnetic particles to flow toward a direction proximate to the magnetic ink layer due to a magnetic field force of the magnetic ink layer, and flow to a space between the cover plate and the bending portion.

In some embodiments, the method for manufacturing the display module further includes: forming a second frame on the side of the cover plate proximate to the display panel, the second frame being connected to the first frame to form a box-frame surrounding the display panel. The second frame is formed synchronously with the first retaining wall, or the second frame is formed synchronously with the second retaining wall.

In some embodiments, the method for manufacturing the display module further includes: forming a second frame on the side of the cover plate proximate to the display panel, the second frame being connected to the first frame to form a box-frame surrounding the display panel.

Forming the second frame includes: forming a third retaining wall on the edge region of the cover plate by a printing process, the third retaining wall being formed synchronously with the first retaining wall; forming a fourth retaining wall on a side of the display portion away from the cover plate by a printing process, the fourth retaining wall being formed synchronously with the second retaining wall, and the fourth retaining wall and the third retaining wall having a spacing therebetween; and forming a second filling portion between the third retaining wall and the fourth retaining wall by a printing process or an adhesive pouring process.

In some embodiments, the method for manufacturing the display module further includes, before bending the bending portion to enable the bonding portion to be located on the non-display side of the display portion: forming a third filling portion on a side of the bending portion.

In yet another aspect, a display apparatus is provided. The display apparatus includes the display module according to any one of the embodiments described above, and a middle frame provided around the display module. A distance between the first frame of the display module and a side wall of the middle frame proximate to the display module ranges from 0 to 0.5 mm.

In some embodiments, the middle frame includes a first portion and a second portion. The first portion is provided around the display module, the second portion is connected to an end of the first portion away from the cover plate, and the second portion includes a first surface facing the cover plate. A surface of the first frame away from the cover plate is in contact with the first surface.

### BRIEF DESCRIPTION OF THE DRAWINGS

In order to describe technical solutions in the present disclosure more clearly, the accompanying drawings to be used in some embodiments of the present disclosure will be introduced briefly. Obviously, the accompanying drawings to be described below are merely drawings of some embodiments of the present disclosure, and a person of ordinary skill in the art can obtain other drawings according to those drawings. In addition, the accompanying drawings in the following description may be regarded as schematic diagrams, but are not limitations on actual sizes of products, actual processes of methods and actual timings of signals involved in the embodiments of the present disclosure.
FIG. 1A is a structural diagram of a display apparatus, in accordance with the related art;
FIG. 1B is a cross-sectional structural diagram of the display apparatus in FIG. 1A taken along the section line J-J;
FIG. 2 is a structural diagram of a display apparatus, in accordance with some embodiments;
FIG. 3A is a cross-sectional structural diagram of the display apparatus in FIG. 2 taken along the section line Z-Z;
FIG. 3B is a back structural diagram of the display apparatus in FIG. 3A;
FIG. 4 is a structural diagram of a display module, in accordance with some embodiments;
FIG. 5 is another structural diagram of a display module, in accordance with some embodiments;
FIG. 6 is yet another structural diagram of a display module, in accordance with some embodiments;
FIG. 7 is still another structural diagram of a display module, in accordance with some embodiments;
FIG. 8 is a cross-sectional structural diagram of the display apparatus in FIG. 1A taken along the section line K-K;
FIG. 9 is another back structural diagram of a display module, in accordance with some embodiments;
FIG. 10 is a cross-sectional structural diagram of the display apparatus in FIG. 2 taken along the section line I-I;
FIG. 11 is yet another back structural diagram of a display module, in accordance with some embodiments;
FIG. 12 is still another back structural diagram of a display module, in accordance with some embodiments;
FIG. 13 is yet still another back structural diagram of a display module, in accordance with some embodiments;
FIG. 14 is yet still another back structural diagram of a display module, in accordance with some embodiments;
FIG. 15 is yet still another back structural diagram of a display module, in accordance with some embodiments;
FIG. 16 is a flowchart of a method for manufacturing a display module, in accordance with some embodiments;
FIG. 17 is a structural diagram of the display module corresponding to step R1 in the method for manufacturing the display module, in accordance with some embodiments;
FIG. 18 is a structural diagram of the display module corresponding to step R2 in the method for manufacturing the display module, in accordance with some embodiments;
FIG. 19 is a flowchart of step R3 in the method for manufacturing the display module, in accordance with some embodiments;
FIG. 20 is a structural diagram of the display module corresponding to step R3 in the method for manufacturing the display module, in accordance with some embodiments;
FIG. 21 is a flowchart of step R33 in the method for manufacturing the display module, in accordance with some embodiments;
FIG. 22 is a structural diagram of the display module corresponding to step R33 in the method for manufacturing the display module, in accordance with some embodiments;
FIG. 23 is a structural diagram of the display module corresponding to step R331 in the method for manufacturing the display module, in accordance with some embodiments;
FIG. 24 is another flowchart of step R33 in the method for manufacturing the display module, in accordance with some embodiments;
FIG. 25 is another structural diagram of the display module corresponding to step R33 in the method for manufacturing the display module, in accordance with some embodiments;
FIG. 26 is yet another structural diagram of the display module corresponding to step R33 in the method for manufacturing the display module, in accordance with some embodiments;
FIG. 27 is a flowchart of step R1 in the method for manufacturing the display module, in accordance with some embodiments;
FIG. 28 is a structural diagram of the display module corresponding to step R1 in the method for manufacturing the display module, in accordance with some embodiments;
FIG. 29 is another flowchart of a method for manufacturing a display module, in accordance with some embodiments;
FIG. 30 is a structural diagram of the display module corresponding to step R4 in the method for manufacturing the display module, in accordance with some embodiments;
FIG. 31 is another structural diagram of the display module corresponding to step R4 in the method for manufacturing the display module, in accordance with some embodiments;
FIG. 32 is yet another structural diagram of the display module corresponding to step R4 in the method for manufacturing the display module, in accordance with some embodiments;
FIG. 33A is a cross-sectional structural diagram of the display module in FIG. 32 taken along the section line H-H;
FIG. 33B is a cross-sectional structural diagram of the display module in FIG. 32 taken along the section line G-G;
FIG. 34 is yet another flowchart of a method for manufacturing a display module, in accordance with some embodiments;
FIG. 35 is a structural diagram of the display module corresponding to step R31' in the method for manufacturing the display module, in accordance with some embodiments;
FIG. 36 is another structural diagram of the display module corresponding to step R31' in the method for manufacturing the display module, in accordance with some embodiments;
FIG. 37 is still another flowchart of a method for manufacturing a display module, in accordance with some embodiments;
FIG. 38 is a structural diagram of the display module corresponding to step R31A in the method for manufacturing the display module, in accordance with some embodiments;
FIG. 39 is a structural diagram of the display module corresponding to step R32A in the method for manufacturing the display module, in accordance with some embodiments;
FIG. 40 is a structural diagram of the display module corresponding to step R33A in the method for manufacturing the display module, in accordance with some embodiments;
FIG. 41 is a flowchart of step R33A in the method for manufacturing the display module, in accordance with some embodiments;
FIG. 42 is a structural diagram of the display module corresponding to step R331A in the method for manufacturing the display module, in accordance with some embodiments;
FIG. 43 is a structural diagram of the display module corresponding to step R332A in the method for manufacturing the display module, in accordance with some embodiments; and
FIG. 44 is a structural diagram of the display module corresponding to step R3A in the method for manufacturing the display module, in accordance with some embodiments.

### DETAILED DESCRIPTION

The technical solutions in some embodiments of the present disclosure will be described clearly and completely below with reference to the accompanying drawings. Obviously, the described embodiments are merely some but not all embodiments of the present disclosure. All other embodiments obtained by a person of ordinary skill in the art based on embodiments provided in the present disclosure shall be included in the protection scope of the present disclosure.

Unless the context requires otherwise, throughout the specification and the claims, the term "comprise" and other forms thereof such as the third-person singular form "comprises" and the present participle form "comprising" are construed as an open and inclusive meaning, i.e., "including, but not limited to." In the description of the specification, the terms such as "one embodiment," "some embodiments," "exemplary embodiments," "example," "specific example," or "some examples" are intended to indicate that specific features, structures, materials, or characteristics related to the embodiment(s) or example(s) are included in at least one embodiment or example of the present disclosure. Schematic representations of the above terms do not necessarily refer to the same embodiment(s) or example(s). In addition, the specific features, structures, materials, or characteristics described may be included in any one or more embodiments or examples in any suitable manner.

Hereinafter, terms such as "first" and "second" are used for descriptive purposes only, and are not to be construed as indicating or implying the relative importance or implicitly indicating the number of indicated technical features. Thus, features defined with "first" and "second" may explicitly or implicitly include one or more of the features. In the description of the embodiments of the present disclosure, the term "a plurality of" or "multiple" means two or more unless otherwise specified.

Some embodiments may be described using the terms "coupled," "connected" and their derivatives. The term "connected" should be understood in a broad sense; for example, "connected" may mean a fixed connection, a detachable connection, or an integrated connection; and "connected" may mean being directly connected or indirectly connected through an intermediate medium. The term "coupled," for example, indicates that two or more components are in direct physical or electrical contact. The term "coupled" or "communicatively coupled" may also indicate that two or more components are not in direct contact with each other, but still cooperate or interact with each other. The embodiments disclosed herein are not necessarily limited to the context herein.

The phrase "at least one of A, B and C" has the same meaning as the phrase "at least one of A, B or C," both including the following combinations of A, B and C: only A, only B, only C, a combination of A and B, a combination of A and C, a combination of B and C, and a combination of A, B and C.

The phrase "A and/or B" includes the following three combinations: only A, only B, and a combination of A and B.

As used herein, the term "if" is, optionally, construed as "when" or "in a case where" or "in response to determining that" or "in response to detecting," depending on the context. Similarly, depending on the context, the phrase "if it is determined that" or "if [a stated condition or event] is detected" is optionally construed as "in a case where it is determined that" or "in response to determining that" or "in a case where [the stated condition or event] is detected" or "in response to detecting [the stated condition or event].

The use of the phrase "applicable to" or "configured to" herein means an open and inclusive expression, which does not exclude devices that are applicable to or configured to perform additional tasks or steps.

In addition, the use of the phrase "based on" is meant to be open and inclusive, since a process, step, calculation, or another action that is "based on" one or more of the stated conditions or values may, in practice, be based on or according to additional conditions or values exceeding those stated.

The term such as "about," "substantially" or "approximately" as used herein includes a stated value and an average value within an acceptable range of deviation of a particular value, and the acceptable range of deviation is determined, for example, by a person of ordinary skill in the art, considering measurement in question and errors (i.e., limitations of a measurement system) associated with measurement of a particular quantity.

The term such as "parallel," "perpendicular" or "equal" as used herein includes a stated condition and a condition similar to the stated condition within an acceptable range of deviation, and the acceptable range of deviation is determined, for example, by a person of ordinary skill in the art, considering measurement in question and errors (i.e., limitations of a measurement system) associated with measurement of a particular quantity. For example, the term "parallel" includes absolute parallelism and approximate parallelism, and an acceptable range of deviation of the approximate parallelism may be, for example, a deviation within 5°; the term "perpendicular" includes absolute perpendicularity and approximate perpendicularity, and an acceptable range of deviation of the approximate perpendicularity may also be, for example, a deviation within 5°; and the term "equal" includes absolute equality and approximate equality, and an acceptable range of deviation of the approximate equality may be, for example, a difference between two equals being less than or equal to 5% of either of the two equals.

It should be understood that if a layer or element is referred to as being on another layer or substrate, the layer or element may be directly on the another layer or substrate, or there may be intermediate layer(s) between the layer or element and the another layer or substrate.

Exemplary embodiments are described herein with reference to sectional views and/or plan views that are schematic illustrations of idealized embodiments. In the accompanying drawings, thicknesses of layers and sizes of regions/areas are enlarged for clarity. Variations in shape relative to the accompanying drawings due to, for example, manufacturing technologies and/or tolerances may be envisaged. Therefore, the exemplary embodiments should not be construed as being limited to the shapes of the regions shown herein, but including shape deviations due to, for example, manufacturing. For example, an etched region/area shown to have a rectangular shape generally has a feature being curved. Therefore, the regions/areas shown in the accompanying drawings are schematic in nature, and their shapes are not intended to show actual shapes of the regions in a device, and are not intended to limit the scope of the exemplary embodiments.

It will be noted that, a reference character, for example "217/218" presented in the accompanying drawings of the present disclosure means that a component may be a component designated by "217" or another component designated by "218", and other similar reference characters presented in the accompanying drawings also follow the above description.

For ease of description below, an XYZ coordinate system is established, in which a Z direction is a thickness direction of the display apparatus 1000, an XY plane is perpendicular to the Z direction, and an X direction crosses a Y direction. For example, the X direction and the Y direction are perpendicular to each other.

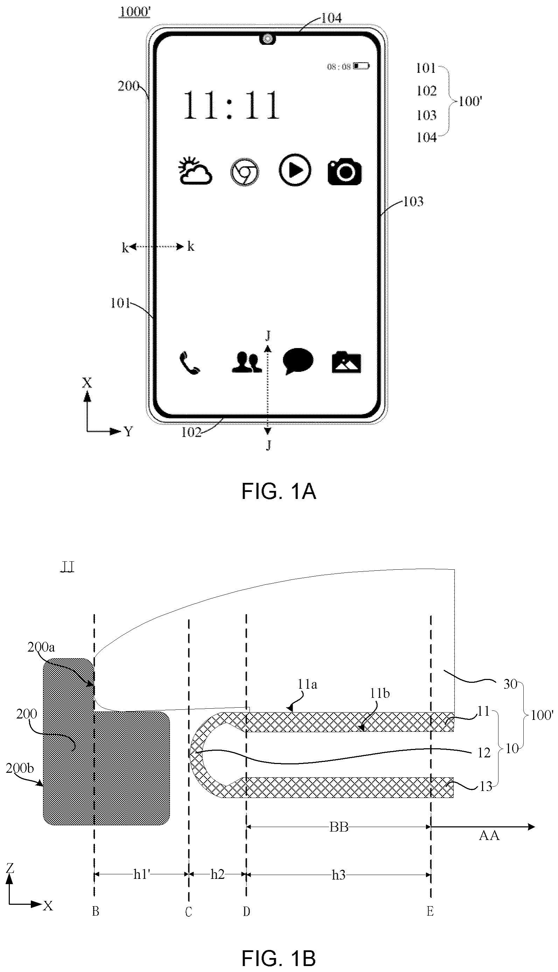

As shown in FIG. 1A, FIG. 1A is a structural diagram of a display apparatus 1000' provided in the related art. The display apparatus 1000' includes a display module 100' and a middle frame 200 provided around the display module 100', in which the display module 100' includes a left frame 101, a lower frame 102, a right frame 103, and an upper frame 104.

As shown in FIG. 1B, FIG. 1B is a cross-sectional view of the display apparatus 1000' in FIG. 1A taken along the section line J-J. The display module 100' includes a display panel 10. The display panel 10 includes a display portion 11, a bending portion 12 and a bonding portion 13 that are connected to each other in sequence. The bending portion 12 is bent to enable the bonding portion 13 to be located on a non-display side 11b of the display portion 11. The bending portion 12 and the bonding portion 13 are located at the position of the lower frame 102 of the display module.

The display portion 11 includes a display area AA (i.e., an area in the display portion 11 for displaying images), and a non-display area BB surrounding the display area AA (i.e., an area in the display portion 11 surrounding the display area AA).

The middle frame 200 includes an inner side wall 200a and an outer side wall 200b.

A width of the lower frame 102 of the display module 100' is a distance from a demarcation line of the display area AA and the non-display area BB of the display portion 11, to the inner side wall 200a of the middle frame 200 on the same side as the lower frame 102, that is, the distance from the dotted line B to the dotted line E along the X direction in FIG. 1B. The width of the lower frame 102 includes h1', h2 and h3.

Here, h1' is a distance from a tangent line, in the Z direction, of an outer edge of the bending portion 12 to the inner side wall 200a of the middle frame 200; h2 is a width of the bending portion 12 in the X direction; h2 is a width of the bending portion 12 in the X direction after being bent; and h3 is a width of a portion, located at the position of the lower frame 102, of the non-display area BB of the display portion 11.

In order to increase the proportion of the display area AA of the display portion 11 in the display module 100', the width of the lower frame 102 needs to be reduced. The magnitude of h3 is related to the wiring design of the display panel 10, and it is relatively difficult to reduce the value of h3 due to the influence of the processing accuracy. The magnitude of h2 may be reduced by decreasing the bending radius of the bending portion 12. However, the risk of fracture of the bending portion 12 increases as the bending radius is reduced, and it is difficult to ensure the reliability during subsequent use. Moreover, since the bending portion 12 of the display panel 10 is relatively fragile, the bending portion 12 of the display panel 10 is susceptible to swaying when the display apparatus 1000' falls or rolls; and the inner side wall 200a of the middle frame 200 is susceptible to deformation under the impact of an external force. As a result, if the distance between the middle frame 200 and the bending portion 12 is too small, the middle frame 200 will crush the bending portion 12 of the display panel 10, causing the display panel 10 to display abnormally. Therefore, the middle frame 200 and the bending portion 12 need to have a certain gap therebetween, that is, h1' needs to have a certain magnitude to avoid the inner side wall 200a of the middle frame 200 from bumping against the bending portion 12 of the display panel 10 due to the deforming of the inner side wall 200a of the middle frame 200 during the falling or rolling process of the display apparatus 1000'. As such, if the value of h1' is decreased to reduce the width of the lower frame 102, the falling reliability of the display apparatus 1000' will be reduced.

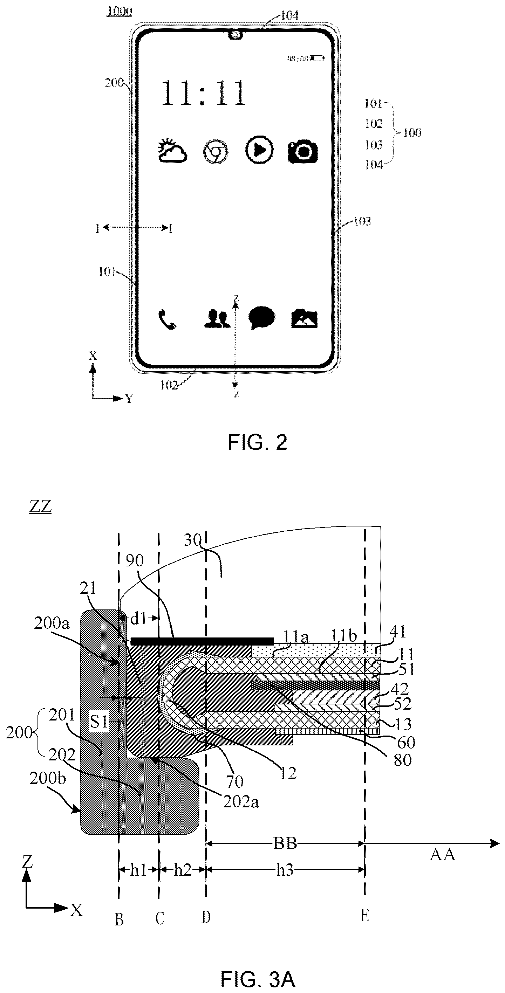

In light of this, as shown in FIG. 2, some embodiments of the present disclosure provide a display apparatus 1000. The display apparatus 1000 includes a display module 100 and a middle frame 200. The middle frame 200 is provided around the display module 100 for supporting the display module 100.

For example, the display apparatus 1000 may be any product or component having a display function, such as a television set, a display monitor, a laptop computer, a tablet computer, a mobile phone, a navigator, or the like. The display apparatus 1000 is illustrated in FIG. 2 as an example of a mobile phone.

For example, the display apparatus 1000 may be a liquid crystal display (LCD) apparatus, or the display apparatus 1000 may be an electroluminescent display apparatus or a photoluminescent display apparatus. In a case where the display apparatus 1000 is an electroluminescent display apparatus, the electroluminescent display apparatus may be an organic electroluminescent (organic light-emitting diode, OLED for short) display apparatus or a quantum dot electroluminescent (quantum dot light-emitting diode, QLED for short) display apparatus. In a case where the display apparatus 1000 is a photoluminescent display apparatus, the photoluminescent display apparatus may be a quantum dot photoluminescent display apparatus.

The display module 100 includes a display area and a frame area surrounding the display area, in which the display area of the display module 100 and the display area AA of the display portion 11 are the same area, and the frame area of the display module 100 includes the left frame 101, the lower frame 102, the right frame 103, and the upper frame 104. It should be understood that the terms of orientation, such as "upper," "lower," "left," right," and the like used in the embodiments of the present application for describing the frame of the display module 100 are mainly based on the orientation in which the display module 100 is depicted in FIG. 2, with the negative direction of the X-axis as lower, the positive direction of the X-axis as upper, the negative direction of the Y-axis as left, and the positive direction of the Y-axis as right.

The structure of the display module 100 will be described in detail below.

FIG. 3A is a cross-sectional view of the display apparatus 1000 in FIG. 2 taken along the section line Z-Z. As shown in FIG. 3A, the display module 100 includes a display panel 10. The display panel 10 includes a display portion 11, a bending portion 12, and a bonding portion 13 that are connected to each other in sequence.

The display portion 11 of the display panel 10 is used for displaying images. The display portion 11 includes a display area AA for displaying images. In a display apparatus 1000 with a high screen-to-body ratio, such as a full screen, almost the entire area of the display portion 11 is the display area AA. In a display apparatus 1000 with a low screen-to-body ratio, the display portion 11 further includes a non-display area BB surrounding the display area AA; and in this case, the non-display area BB included in the display portion 11 is at the position of the lower frame 102 of the display module.

To implement the image display function of the display panel 10, the display portion 11 is provided with display devices formed therein.

For example, the display apparatus may be an organic light-emitting diode (OLED) device or a liquid crystal display device, which may be set according to the actual needs of the user.

For example, in a case where the display panel 10 is an OLED display panel, the OLED display panel includes an array substrate and a pixel definition layer located on the array substrate, in which pixel definition regions of the pixel definition layer are each provided therein with an anode, a hole injection layer, a hole transport layer, a light-emitting layer, an electron transport layer, an electron injection layer, and a cathode in sequence.

As another example, in a case where the display panel 10 is a liquid crystal display panel, the liquid crystal display panel includes an array substrate and a color film substrate provided opposite each other, and a liquid crystal layer located between the array substrate and the color film substrate.

The bending portion 12 is bendable, and the bonding portion 13 is provided on the non-display side 11b of the display portion 11 by the bending action of the bending portion 12. In order to implement the bending of the bending portion 12 of the display panel 10, the display panel 10 in the embodiments may be a flexible display panel, which is made of a flexible material, and the selected flexible material may be made of a polymer material such as polyethylene terephthalate, polyether sulphone, polyethylene naphthalate, polyimide, or the like. It will be noted that the present disclosure does not make a specific limitation on the material of the flexible display panel, and no matter what kind of material is selected (including all flexible materials available for use as a flexible substrate in the prior art), a certain degree of stretchability is required to form the flexible display substrate. In the specific manufacturing process, a flexible material, which meets the stretchability requirements, needs to be selected according to the actual demand for the display panel 10.

For example, the bending of the display panel 10 may be that the bending portion 12 is bent, while the display portion 11 and the bonding portion 13, which are located on both sides of the bending portion 12, are not bent. Further, the bending of the display panel 10 may be that the bending portion 12 is bent greatly, and a part of the display portion 11 proximate to an edge of the bending portion 12 may be slightly bent, so as to form a curved display apparatus.

For example, the outer wall of the bending portion 12 of the display panel 10 (a side wall of the bending portion 12 proximate to the middle frame 200) may be covered with a protective adhesive layer 70, for reducing the probability of the display panel 10 being broken. The protective adhesive layer 70 may be, for example, a micro coating layer (MCL).

It will be understood that only an edge portion of the display portion 11, that is, the portion of the display portion 11 corresponding to the bonding portion 13, is illustrated in FIG. 3A. In fact, the display portion 11 continues to extend along the X direction (the rightward direction) in FIG. 3A, and the bonding portion 13, after being provided on the non-display side 11b of the display portion 11 due to bending, corresponds to only a partial area of the display portion 11.

The bonding portion 13 may be located on any one position of the upper, lower, left, and right sides of the display portion 11, that is, located at any position of the left frame 101, the lower frame 102, the right frame 103, and the upper frame 104 of the display module. Alternatively, the display apparatus 1000 may include multiple bonding portions 13, and the multiple bonding portions 13 may be located on any at least two sides of the upper, lower, left, and right sides of the display portion 11, that is, located at any at least two positions of the left frame 101, the lower frame 102, the right frame 103, and the upper frame 104 of the display module. The following description will be made by taking an example that there is one bonding portion 13, which is located at the lower side of the display portion 11, that is, at the lower frame 102 of the display module.

With continuing reference to FIG. 3A, the display module 100 further includes a cover plate 30. The cover plate 30 is provided on the display side 11a of the display portion 11 in a stack. The cover plate 30 can separate the display panel 10 from the external environment, providing protection for the display panel 10.

Here, a boundary of the cover plate 30 is farther away from the display portion 11 than a boundary of the bending portion 12 farthest from the display portion 11. That is, an orthographic projection of the boundary of the bending portion 12 farthest from the display portion 11 on the cover plate 30 lies within the cover plate 30, and has a distance d1 from the boundary of the cover plate 30.

For example, the cover plate 30 may be a cover plate 30 of a single layer, or may be a cover plate 30 of multiple layers laminated together by an adhesive material.

For example, the cover plate 30 may be a silicate glass cover plate; the cover plate 30 may be curved glass or ultra-thin glass; the cover plate 30 may be a flexible polymer film cover plate, which may be of transparent polyimide or polyethylene terephthalate (PET) or polyurethane; or the cover plate 30 may be a combination of layers of the above polymer films, or a combination of the above polymer films and glass.

The middle frame 200 is provided around the display panel 10 (specifically, it means that the middle frame 200 is provided around a portion of the display panel 10 after arranging the bonding portion 13 to the back side of the display portion 11 by bending). The middle frame 200 includes an inner side wall 200a and an outer side wall 200b, in which the inner side wall 200a is a side wall of the middle frame 200 proximate to the bending portion 12, and the outer side wall 200b is a side wall of the middle frame 200 away from the bending portion 12.

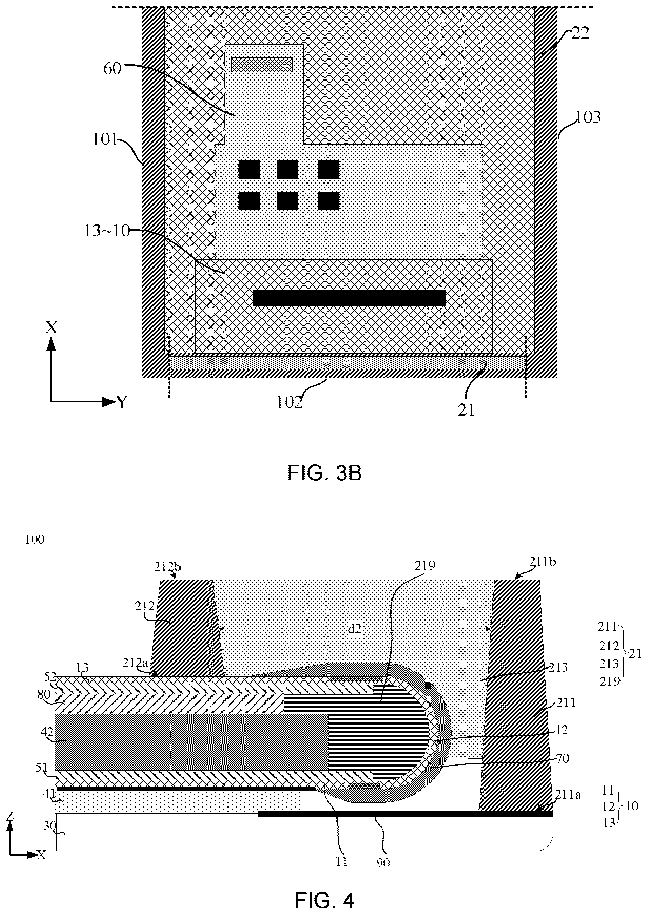

As shown in FIGS. 3A and 3B, in which FIG. 3B is a structural diagram of the display apparatus 1000 of FIG. 2 on the back side thereof (i.e., the side on which the bonding portion 13 in the display apparatus 1000 is located), the display module 100 further includes a first frame 21. The first frame 21 is provided on the side of the cover plate 30 proximate to the display panel 10 and extends along a side edge of the cover plate 30 corresponding to the bonding portion 13. A portion of the first frame 21 is located between the bending portion 12 and the inner side wall 200a of the middle frame 200.

It will be noted that the dotted lines on both sides of the first frame 21 in FIG. 3B refer to the boundaries of the first frame 21 in the Y direction.

By providing the first frame 21 between the bending portion 12 and the inner side wall 200a of the middle frame 200, the first frame 21 can protect the bending portion 12 during a process of falling, rolling, etc., of the display apparatus 1000. Compared to the related art illustrated in FIG. 1B, in the embodiments illustrated in FIG. 3A, a distance between a tangent line, in the Z direction, of an outer edge of the bending portion 12 to the inner side wall 200a of the middle frame 200 may be reduced by providing the first frame 21 to protect the bending portion 12 during the process of falling, rolling, etc., of the display apparatus 1000. That is, a distance h1 from the tangent line, in the Z direction, of the outer edge of the bending portion 12 to the inner side wall 200a of the middle frame 200 in FIG. 3A is less than the distance h1' from the tangent line, in the Z direction, of the outer edge of the bending portion 12 to the inner side wall 200a of the middle frame 200 in FIG. 1B, which is conducive to reducing the size of the lower frame 102 of the display module 100 and further implementing the narrow frame of the display apparatus 1000.

A material with a relatively small elasticity modulus may be selected as the material of the first frame 21, so as to provide a cushioning space for the deformation of the middle frame 200 in a case where the middle frame 200 is subjected to an external impact force, thereby avoiding the stresses being transferred to the bending portion 12. The first frame 21 has an elasticity modulus less than an elasticity modulus of the middle frame 200, and may be made of a material such as a resin.

In some embodiments, as shown in FIG. 3A, a distance S1 between the first frame 21 and the inner side wall 200a of the middle frame 200 ranges from 0 to 0.5 mm.

For example, the distance S1 between the first frame 21 and the inner side wall 200a of the middle frame 200 may be 0, 0.1 mm, 0.12 mm, 0.2 mm, 0.26 mm, 0.3 mm, 0.36 mm, 0.4 mm, 0.46 mm, or 0.5 mm.

The distance S1 between the first frame 21 and the inner side wall 200a of the middle frame 200 may be 0. In this case, the first frame 21 is in contact with the inner side wall 200a of the middle frame 200, so the distance h1 from the tangent line, in the Z direction, of the outer edge of the bending portion 12 to the inner side wall 200a of the middle frame 200 is minimized, greatly reducing the width of the lower frame 102 of the display module 100. The distance S1 between the first frame 21 and the inner side wall 200a of the middle frame 200 may be greater than 0. In this case, there is a gap between the first frame 21 and the inner side wall 200a of the middle frame 200, so as to meet a process margin for assembling the display module, and to provide a space for releasing stresses for deformation (e.g., deformation brought about by thermal expansion and cold contraction) of some components in the display module.

It can be understood that in a case where there is a gap between the first frame 21 and the inner side wall 200a of the middle frame 200, a width of the gap is much less than a width of a gap between the bending portion and the middle frame in the related art. Therefore, even if there is the above gap between the first frame 21 and the inner side wall 200a of the middle frame 200, it is still possible to accomplish the effect of reducing the width of the lower frame 102 of the display module 100.

In some embodiments, as shown in FIG. 3A, the middle frame 200 includes a first portion 201 and a second portion 202, in which the first portion 201 is provided around the display module 100, the second portion 202 is connected to an end of the first portion 201 away from the cover plate 30, and the second portion 202 and the first portion 201 are combined together in an "L" shape.

The second portion 202 includes a first surface 202a facing the cover plate 30. A surface of the first frame 21 away from the cover plate 30 is in contact with the first surface 202a, so as to allow the second portion 202 of the middle frame 200 to support the first frame 21, which is conducive to improving the stability of the first frame 21 and further improving the protection effect of the bending portion 12 of the display panel 10.

In some embodiments, as shown in FIG. 3A, the display module 100 further includes a first back film 51 and a second back film 52. The first back film 51 is provided on the non-display side 11b of the display portion 11, and the second back film 52 is provided on a side of the bonding portion 13 proximate to the display portion 11 and is closer to the display portion 11 than the bonding portion 13.

By providing the first back film 51 and the second back film 52, after the display panel 10 is bent by the bending action of the bending portion 12 to enable the bonding portion 13 to be provided on the non-display side of the display portion 11, the first back film 51 and the second back film 52 can provide the support force to the display portion 11 and the bonding portion 13 of the display panel 10, respectively, so as to attain a better bending effect.

For example, a material of the first back film 51 and a material of the second back film 52 may be one of polyethylene terephthalate (PET), polyimide (PI), and cyclo olefin polymer (COP).

For example, the first back film 51 and the display portion 11 may be fixed by an optically clear adhesive (OCA) therebetween, and the second back film 52 and the bonding portion 13 may be fixed by an optically clear adhesive (OCA) therebetween, which is conducive to ensuring the light transmittance of the display panel 10.

In some embodiments, as shown in FIG. 3A, the display module 100 further includes a heat dissipation film 80. The heat dissipation film 80 is stacked on a side of the first back film 51 away from the display portion 11 and is provided between the display portion 11 and the bonding portion 13, which can serve to dissipate heat.

For example, the heat dissipation film 80 may be a composite film composed of mesh adhesive, foam and copper foil.

In some embodiments, as shown in FIG. 3A, the display module 100 further includes a spacer part 42. The spacer part 42 is provided between the second back film 52 and the heat dissipation film 80, which can increase the strength of the display portion 11 of the display panel 10.

In some embodiments, as shown in FIG. 3A, the display module 100 further includes an adhesive layer 41. The adhesive layer 41 is provided between the cover plate 30 and the display panel 10, for bonding the cover plate 30 to the display panel 10.

For example, the adhesive layer 41 may be made of optically clear adhesive (OCA) or optical clear resin (OCR).

In some embodiments, as shown in FIG. 3A, the display module 100 further includes an ink layer 90. The ink layer 90 is provided on a side of the cover plate 30 proximate to the display panel 10 and is located on an edge region of the cover plate 30. The main function of the ink layer 90 is to prevent the display panel 10 from leaking light laterally.

In some embodiments, as shown in FIG. 3A, the display module 100 further includes a flexible circuit board (FPC) cable 60. The FPC cable 60 is provided on a side of the bonding portion 13 away from the display portion 11. The display module 100 further includes a driver chip (not shown in the figure) for providing control signals to the display panel 10, and the FPC cable 60 is used to connect with the driver chip to transmit the control signals provided by the driver chip to the display panel 10.

The structure of the first frame 21 in the display module 100 will be described in detail below.

As shown in FIG. 4, the first frame 21 includes a first retaining wall 211, a second retaining wall 212 and a first filling portion 213. A first end 211a of the first retaining wall 211 is connected to an edge region of the cover plate 30, a first end 212a of the second retaining wall 212 is connected to the bonding portion 13, and the first retaining wall 211 and the second retaining wall 212 have a spacing d2 therebetween. The first filling portion 213 is provided between the first retaining wall 211 and the second retaining wall 212 in a filling manner.

It can be understood that in the embodiments of the present disclosure, the first retaining wall 211 and the second retaining wall 212 may be formed by a printing process, and the first filling portion 213 may be formed by a printing process or an adhesive pouring process. In order to enable the first filling portion 213 to more fully cover the bending portion 12 to better protect the bending portion 12, a material for forming the first filling portion 213 may be a material with a relatively low viscosity, so that when the first filling portion 213 is formed by printing or pouring adhesive, the material of the first filling portion 213 can flow more easily toward the direction of the cover plate 30 to cover more of the bending portion 12.

The first retaining wall 211 and the second retaining wall 212 serve as a blocking structure for the first filling portion 213 to prevent the material of the first filling portion 213 from overflowing. In addition, in order to improve the molding rate of the first retaining wall 211 and the second retaining wall 212 formed by printing, a material for forming the first retaining wall 211 and a material for forming the second retaining wall 212 may be materials with a high viscosity. That is, the viscosity of the material for forming the first retaining wall 211 and the viscosity of the material for forming the second retaining wall 212 are greater than the viscosity of the material for forming the first filling portion 213.

As described above, the first frame 21 may be made of a material with a low elasticity modulus. On this basis, for example, the materials for forming the first retaining wall 211, the second retaining wall 212 and the first filling portion 213 may be polyimide or epoxy resin.

In some embodiments, the materials for forming the first retaining wall 211, the second retaining wall 212 and the first filling portion 213 are the same, but have different viscosities. In this case, the first retaining wall 211, the second retaining wall 212 and the first filling portion 213 after being cured and molded are in a one-piece structure, that is, the first frame 21 is in a one-piece structure. It can be understood that the "same material" means that the first retaining wall 211, the second retaining wall 212 and the first filling portion 213 have a same main material, and different types of other materials or a same type of another material but in different amounts may be mixed in the first retaining wall 211, the second retaining wall 212 and the first filling portion 213. For example, adding another material with different amounts into the same main material may enable the first filling portion 213 to have a low viscosity, and the first retaining wall 211 and the second retaining wall 212 to have a high viscosity.

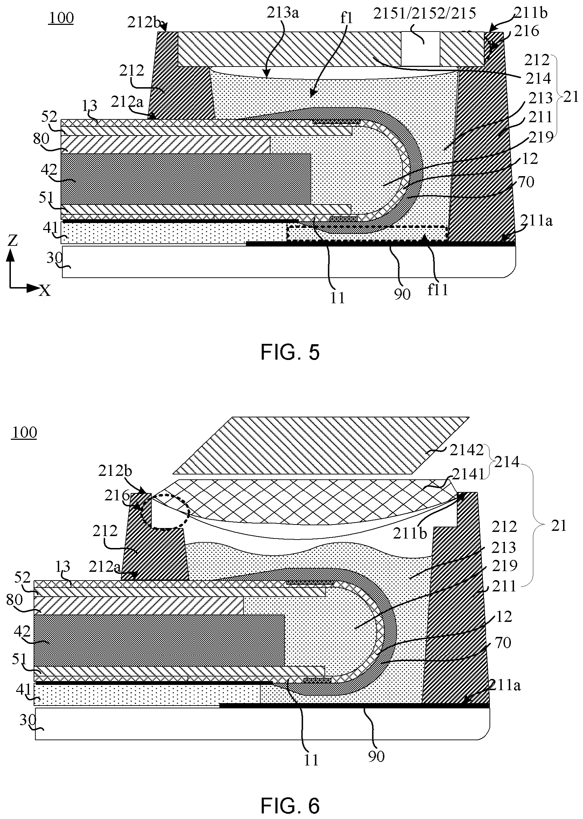

On this basis, as shown in FIG. 5, since the material for forming the first filling portion 213 has a relatively low viscosity, that is, the material for forming the first filling portion 213 has a relatively high fluidity, after the material for forming the first filling portion 213 provided between the first retaining wall 211 and the second retaining wall 212 is cured, a first surface 213a thereof (i.e., a surface of the first filling portion 213 on a side thereof away from the cover plate 30) partially produces a slight recess in a direction toward the cover plate 30, that is, the surface of the first filling portion 213 on a side thereof away from the cover plate 30 is not flat.

In some embodiments, as shown in FIG. 5, the first frame 21 further includes a top cover 214 provided therein with a plurality of through holes 215. The through holes 215 may include a pouring hole 2151 and an exhaust hole 2152.

The top cover 214 is connected to ends, away from the cover plate 30, of the first retaining wall 211 and the second retaining wall 212, that is, the top cover 214 is connected to a second end 211b of the first retaining wall 211 and a second end 212b of the second retaining wall 212.

The top cover 214, the first retaining wall 211 and the second retaining wall 212 form an accommodation space f1 enclosed thereby, and the accommodation space f1 is filled with the first filling portion 213.

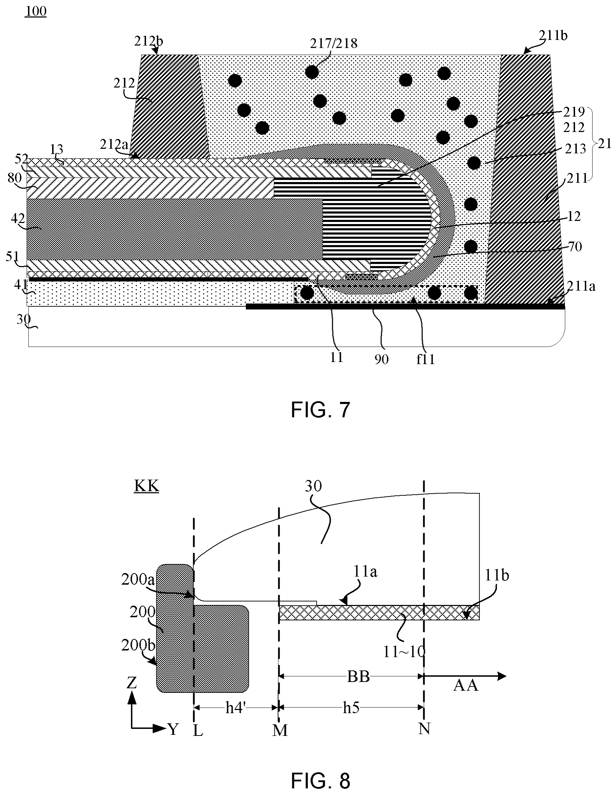

An adhesive material for forming the first filling portion 213 may enter the accommodation space f1 through the pouring hole 2151. The exhaust hole 2152 may be used to evacuate the accommodation space f1, which is beneficial for the adhesive material for forming the first filling portion 213 to flow toward a side proximate to the cover plate 30, and flow to a space between the cover plate 30 and the bending portion 12, that is, a region f11 enclosed by the dotted box in FIGS. 7 and 8, which may increase the contact area of the first filling portion 213 and the bending portion 12, which is conducive to further protecting the bending portion 12 of the display panel 10 and improving the crush-resistance strength of the bending portion 12 of the display panel 10.

On this basis, as shown in FIG. 5, the ends, away from the cover plate 30, of the first retaining wall 211 and the second retaining wall 212, that is, the second end 211b of the first retaining wall 211 and the second end 212b of the second retaining wall 212, are each provided with a notch 216, and edges of the top cover 214 are placed within the notches 216, which is conducive to improving the stability of the top cover 214.

For example, as shown in FIG. 6, the top cover 214 may include a support layer 2141 and a body layer 2142 that are arranged in a stack, and the support layer 2141 is closer to the cover plate 30 than the body layer 2142. The support layer 2141 is used to support the body layer 2142, which is conducive to further improving the stability of the top cover 214.

Here, a material of the support layer 2141 may include, for example, a metal mesh. In a case where the material of the support layer 2141 is the metal mesh, edges of the body layer 2142 may be connected to the first retaining wall 211 and the second retaining wall 212 through mesh holes of the metal mesh.

A material for forming the body layer 2142 may be, for example, the same as the material for forming the first retaining wall 211 or the second retaining wall 212. Since the viscosity of the material for forming the first retaining wall 211 or the second retaining wall 212 is greater than the viscosity of the material for forming the first filling portion 213, a viscosity of the material for forming the body layer 2142 is also greater than the viscosity of the first filling portion 213, which is conducive to molding when the body layer 2142 is formed by a printing process, thereby improving the molding rate.

In some embodiments, if the first retaining wall 211, the second retaining wall 212, the first filling portion 213, and the body layer 2142 are formed by the same material, the first retaining wall 211, the second retaining wall 212, the first filling portion 213, and the body layer 2142 after being molded are in a one-piece structure, and the support layer 2141 is embedded in the one-piece structure formed by the first retaining wall 211, the second retaining wall 212, the first filling portion 213, and the body layer 2142.

In some embodiments, as shown in FIG. 7, the first filling portion 213 is provided therein with magnetic particles 217.

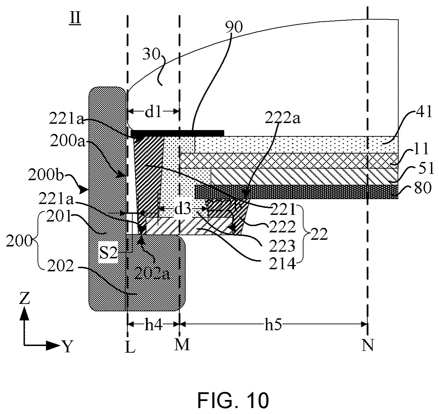

In the process of forming the first filling portion 213, a magnetic field force is applied on a side of the display module 100 proximate to the cover plate 30, and the magnetic particles 217 move toward the direction of the cover plate 30 under the action of the magnetic field force, which is beneficial for the adhesive material for forming the first filling portion 213 to flow toward a side proximate to the cover plate 30, and flow to a space between the cover plate 30 and the bending portion 12, that is, a region f11 enclosed by the dotted box in FIG. 10, which may increase the contact area of the first filling portion 213 and the bending portion 12, which is conducive to further protecting the bending portion 12 of the display panel 10 and improving the crush-resistance strength of the bending portion 12 of the display panel 10.

Alternatively, the material of the ink layer 90 is set to magnetic ink. In the process of forming the first filling portion 213, the adhesive material for forming the first filling portion 213 flows toward a side proximate to the cover plate 30 under the action of the magnetic field force of the magnetic ink, and flows to a space between the cover plate 30 and the bending portion 12, that is, a region f11 enclosed by the dotted box in FIG. 10. The formed first filling portion 213 is in contact with the ink layer 90, and a part of the first filling portion 213 extends between the bending portion 12 and the ink layer 90, which may increase the contact area of the first filling portion 213 and the bending portion 12, which is conducive to further protecting the bending portion 12 of the display panel 10 and improving the crush-resistance strength of the bending portion 12 of the display panel 10.

For example, the magnetic particles 217 include at least one type of magnetic nanoparticles or magnetic polymer particles. For example, the magnetic particles 217 may be magnetic ferroferric oxide or polystyrene microspheres.

For example, the magnetic particles 217 have a diameter ranging from 50 nm to 100 nm. For example, the diameter may be 50 nm, 60 nm, 70 nm, 80 nm, 90 nm, or 100 nm.

For example, a concentration of the magnetic particles 217 in the first filling portion 213 ranges from 3% to 10%. For example, the concentration may be 3%, 4%, 5%, 6%, 7%, 8%, 9%, or 10%.

In some other embodiments, as shown in FIG. 7, the first filling portion 213 is provided therein with conductive particles 218. By providing the conductive particles 218 in the first filling portion 213, the conductive particles 218 move toward the direction of the cover plate 30 under the action of an electric field force. In the process of forming the first filling portion 213, by applying the electric field force on a side of the display module 100 proximate to the cover plate 30, it is beneficial for the adhesive material for forming the first filling portion 213 to flow toward a side proximate to the cover plate 30, and flow to a space between the cover plate 30 and the bending portion 12, that is, a region f11 enclosed by the dotted box in FIG. 10, which may increase the contact area of the first filling portion 213 and the bending portion 12, which is conducive to further protecting the bending portion 12 of the display panel 10 and improving the crush-resistance strength of the bending portion 12 of the display panel 10.

For example, the conductive particles 218 include at least one type of organic conductive particles or carbon conductive particles. In a case where the conductive particles 218 are organic conductive particles, the organic conductive particles may be, for example, polypropylene conductive particles, polystyrene conductive particles, or polyaniline conductive particles; and in a case where the conductive particles 218 are carbon conductive particles, the carbon conductive particles may be, for example, graphene conductive particles.

For example, the conductive particles 218 have a diameter ranging from 3 µm to 5 µm. For example, the diameter may be 3 µm, 3.5 µm, 4 µm, 4.5 µm, or 5 µm.

For example, a concentration of the conductive particles 218 in the first filling portion 213 ranges from 10% to 15%. For example, the concentration may be 10%, 11%, 12%, 13%, 14% or 15%.

In some embodiments, as shown in FIGS. 4 to 7, the display module 100 further includes a third filling portion 219. The bending portion 12 of the display panel 10 is bent to form a cavity facing the display portion 11. The third filling portion 219 is provided in the cavity formed by the bending portion 12 in a filling manner. By filling the cavity of the bending portion 12 toward the display portion 11 with the third filling portion 219, the bending portion 12 may be further protected, which is conducive to further improving the crush-resistance strength of the bending portion 12.

For example, a material for forming the third filling portion 219 may be the same as the material for forming the first filling portion 213. For example, as shown in FIGS. 5 and 6, the first frame 21 includes the top cover 214. In the process of forming the first filling portion 213 by an adhesive pouring process, the material for forming the first filling portion 213 enters the accommodation space f1 through the pouring hole 2151. The exhaust hole 2152 is used to evacuate the accommodation space f1. When the accommodation space f1 is in a vacuum state, since the accommodation space f1 is connected to the cavity formed by bending the bending portion 12 toward the display portion 11, the material for forming the first filling portion 213 will enter the cavity formed by bending the bending portion 12 toward the display portion 11, so as to form the third filling portion 219. In this case, the material for forming the third filling portion 219 is the same as the material for forming the first filling portion 213.

In the above embodiments, the first filling portion 213 and the third filling portion 219 are formed synchronously. In some other embodiments, the first filling portion 213 and the third filling portion 219 are made of the same material, but may be formed in different steps. For example, before the bending portion 12 is bent to enable the bonding portion 13 to be located on the non-display side 11b of the display portion 11, the third filling portion 219 is formed on a side of the bending portion 12 in advance, and then the bending portion 12 is bent, after which the first frame 21 including the first filling portion 213 is formed.

The material for forming the third filling portion 219 may be different from the material for forming the first filling portion 213. For example, as shown in FIG. 7, before the bending portion 12 is bent to enable the bonding portion 13 to be located on the non-display side 11b of the display portion 11, the third filling portion 219 is formed on a side of the bending portion 12 in advance, and then the bending portion 12 is bent, after which the first frame 21 including the first filling portion 213 is formed. Here, the material for forming the third filling portion 219 is different from the material for forming the first filling portion 213.

Referring again to FIG. 1A, in a case where the bending portion 12 and the bonding portion 13 of the display panel 10 are provided only at the position of the lower frame 102, structures of the display apparatus 1000' at the corresponding positions of the left frame 101, the right frame 103 and the upper frame 104 of the display module 100' are basically the same. The structure of the display apparatus 1000' at the corresponding position of the left frame 101 of the display module 100' will be described below as an example. FIG. 8 is a cross-sectional view of the display apparatus1000' in FIG. 1A taken along the section line K-K.

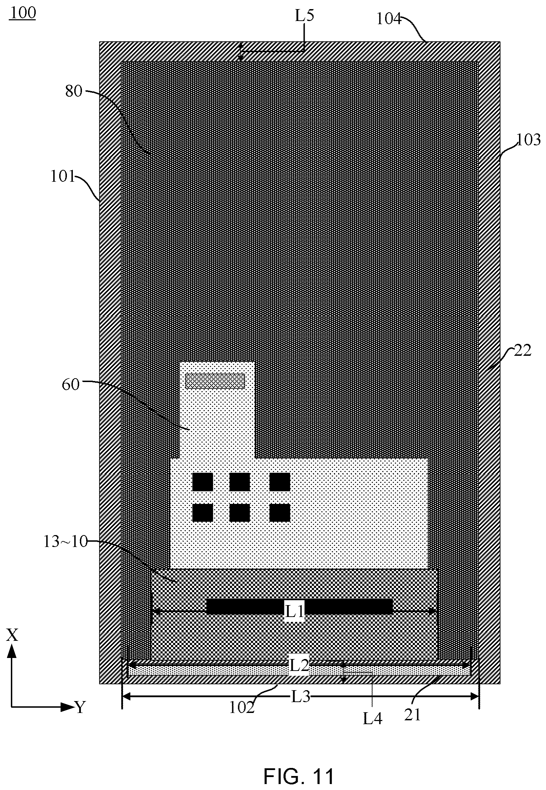

As shown in FIG. 8, a width of the left frame 101 of the display module 100' is a distance from a demarcation line of the display area AA and the non-display area BB of the display portion 11, to the inner side wall 200a of the middle frame 200 on the same side as the left frame 101, that is, the distance from the dotted line L to the dotted line N along the Y direction in FIG. 11. The width of the left frame 101 includes h4' and h5.

Here, h4' is a distance from an edge of the display portion 11 to the inner side wall 200a of the middle frame 200, and h5 is a width of a portion, at the position of the left frame 101, of the non-display area BB of the display portion 11.

In order to increase the proportion of the display area AA of the display portion 11 in the display module 100', the width of the left frame 101 needs to be reduced. The magnitude of h5 is related to the wiring design of the display panel 10, and it is relatively difficult to reduce the value of h5 due to the influence of the processing accuracy. When the display apparatus 1000' falls or rolls, the inner side wall 200a of the middle frame 200 is susceptible to deformation under the impact of an external force. As a result, if the distance between the middle frame 200 and the display portion 11 is too small, the middle frame 200 will crush the display portion 11 of the display panel 10, causing the display panel 10 to display abnormally. Therefore, the middle frame 200 and the bending portion 12 need to have a certain gap therebetween, that is, h4' needs to have a certain magnitude to avoid the inner side wall 200a of the middle frame 200 from bumping against the display portion 11 of the display panel 10 due to the deforming of the inner side wall 200a of the middle frame 200 during the falling or rolling process of the display apparatus 1000'. As such, if the value of h4' is decreased to reduce the width of the left frame 101, the falling reliability of the display apparatus 1000' will be reduced.

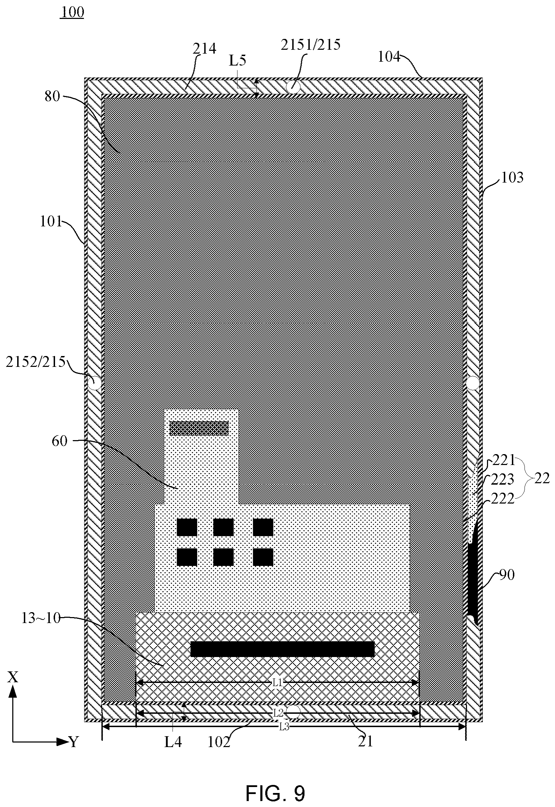

In view of this, as shown in FIG. 9, FIG. 9 is a structural diagram of the display module 100 in some embodiments of the present disclosure. The display module 100 further includes a second frame 22, and the first frame 21 is connected to the second frame 22 to form a box-frame surrounding the display panel 10. The second frame 22 is provided at at least the left frame 101, the right frame 103 and the upper frame 104 of the display module 100.

The above "the second frame 22 being provided at at least the left frame 101, the right frame 103 and the upper frame 104 of the display module 100" means that: the second frame 22 may be provided only at the left frame 101, the right frame 103 and the upper frame 104 of the display module 100; and ends thereof are at a junction of the left frame 101 and the lower frame 102 and at a junction of the right frame 103 and the lower frame 102, respectively, and are connected to the ends of the first frame 21; alternatively, ends of the second frame 22 may extend to the lower frame 102 of the display module 100 and be connected to the ends of the first frame 21 in the lower frame 102, that is, the second frame 22 is provided at the left frame 101, the lower frame 102, the right frame 103, and the upper frame 104 of the display module 100.

It can be understood that in a case where the second frame 22 is provided at the left frame 101, the lower frame 102, the right frame 103, and the upper frame 104 of the display module 100, a portion of the second frame 22 in the lower frame 102 is provided in a region of the lower frame 102 where the first frame 21 is not provided.

Since structures of the display apparatus 1000 at the corresponding positions of the left frame 101, the right frame 103 and the upper frame 104 of the display module 100 are basically the same, the structure of the display apparatus 1000 at the corresponding position of the left frame 101 of the display module 100 will be described below as an example. FIG. 10 is a cross-sectional view of the display apparatus1000 in FIG. 2 taken along the section line I-I.

As shown in FIG. 10, the second frame 22 is provided between an edge of the display portion 11 of the display panel 10 and the inner side wall 200a of the middle frame 200 for protecting the edge of the display portion 11 of the display panel 10, thereby avoiding the inner side wall 200a of the middle frame 200 from bumping against the display portion 11 of the display panel 10 due to the deforming of the inner side wall 200a of the middle frame 200 during the falling or rolling process of the display apparatus 1000, which is conducive to ensuring a normal display of the display panel 10.

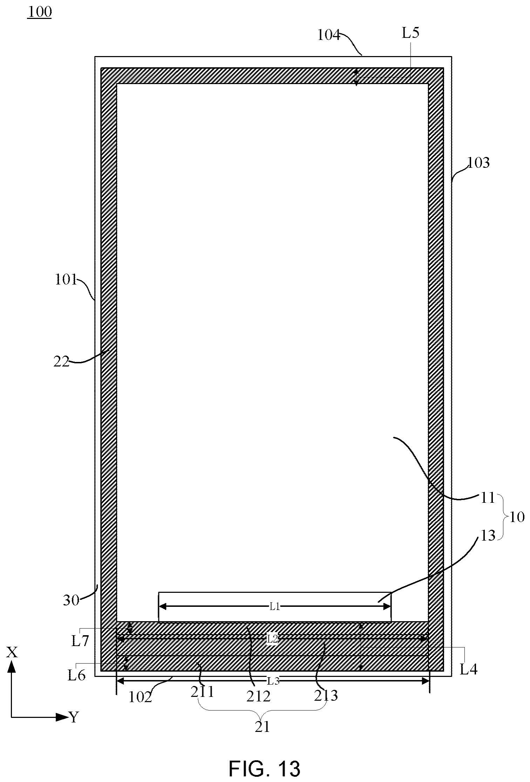

By providing the second frame 22 between the edge of the display portion 11 of the display panel 10 and the inner side wall 200a of the middle frame 200, the second frame 22 can protect the display portion 11 during a process of falling, rolling, etc., of the display apparatus 1000. Compared to the related art illustrated in FIG. 11, in the embodiments illustrated in FIG. 13, a distance from the edge of the display portion 11 to the inner side wall 200a of the middle frame 200 may be reduced by providing the second frame 22 to protect the display portion 11 during the process of falling, rolling, etc., of the display apparatus 1000. That is, the width h4 from the edge of the display portion 11 to the inner side wall 200a of the middle frame 200 in FIG. 13 is less than the width h4' from the edge of the display portion 11 to the inner side wall 200a of the middle frame 200 in FIG. 11, which is conducive to reducing the size of the left frame 101 of the display module 100 and further implementing the narrow frame of the display apparatus 1000.

A material with a relatively small elasticity modulus may be selected as the material of the second frame 22, so as to provide a cushioning space for the deformation of the middle frame 200 in a case where the middle frame 200 is subjected to an external impact force, thereby avoiding the stresses being transferred to the display portion 11. The second frame 22 has an elasticity modulus less than an elasticity modulus of the middle frame 200, and may be made of a material such as a resin.

Similarly, since the second frame 22 also has portions provided at the right frame 103 and the upper frame 104 of the display module 100, sizes of the right frame 103 and the upper frame 104 of the display module 100 may also be reduced, further implementing the narrow frame of the display apparatus 1000.

In some embodiments, continuing to refer to FIG. 10, a distance S2 between the second frame 22 and the inner side wall 200a of the middle frame 200 ranges from 0 to 0.5 mm.

For example, the distance S2 between the second frame 22 and the inner side wall 200a of the middle frame 200 may be 0, 0.1 mm, 0.12 mm, 0.2 mm, 0.26 mm, 0.3 mm, 0.36 mm, 0.4 mm, 0.46 mm, or 0.5 mm.

That is, the distance S2 between the second frame 22 and the inner side wall 200a of the middle frame 200 may be 0. In this case, the second frame 22 is in contact with the inner side wall 200a of the middle frame 200, so the width h1 from the tangent line, in the Z direction, of the outer edge of the bending portion 12 to the inner side wall 200a of the middle frame 200 is minimized, greatly reducing the width of the left frame 101 of the display module 100. The distance S2 between the second frame 22 and the inner side wall 200a of the middle frame 200 may be greater than 0. In this case, there is a gap between the second frame 22 and the inner side wall 200a of the middle frame 200, so as to meet a process margin for assembling the display module, and to provide a space for releasing stresses for deformation (e.g., deformation brought about by thermal expansion and cold contraction) of some components in the display module.

It can be understood that in a case where there is a gap between the second frame 22 and the inner side wall 200a of the middle frame 200, a width of the gap is much less than a width of a gap between the bending portion 12 and the middle frame 200 in the related art. Therefore, even if there is the above gap between the second frame 22 and the inner side wall 200a of the middle frame 200, it is still possible to accomplish the effect of reducing the width of the left frame 101 of the display module 100.

In some embodiments, continuing to refer to FIG. 10, the middle frame 200 includes a first portion 201 and a second portion 202, in which the first portion 201 is provided around the display module 100, the second portion 202 is connected to an end of the first portion 201 away from the cover plate 30, and the second portion 202 and the first portion 201 are combined together in an "L" shape.

The second portion 202 includes a first surface 202a facing the cover plate 30. A surface of the second frame 22 away from the cover plate 30 is in contact with the first surface 202a, so as to allow the second portion 202 of the middle frame 200 to support the second frame 22, which is conducive to improving the stability of the second frame 22 and further improving the protection effect of the display portion 11 of the display panel 10.

In some embodiments, as shown in FIG. 9, a length L2 of the first frame 21 (i.e., a dimension of the first frame 21 in the Y direction) is equal or substantially equal to a length L1 of the bonding portion 13 of the display panel 10 (i.e., a dimension L1 of the bonding portion 13 in the Y direction), and the length L2 of the first frame 21 is less than a length L3 of the lower frame 102 (i.e., a dimension of the lower frame 102 in the Y direction); and a portion of the second frame 22 extends to the lower frame 102 to connect the first frame 21.

It will be noted that the "L2 and L1 being substantially equal" means that in the Y direction, a difference between the length L2 of the first frame 21 and the length L1 of the bonding portion 13 of the display panel 10 is very small, for example, the difference is within a range of ±5 mm.

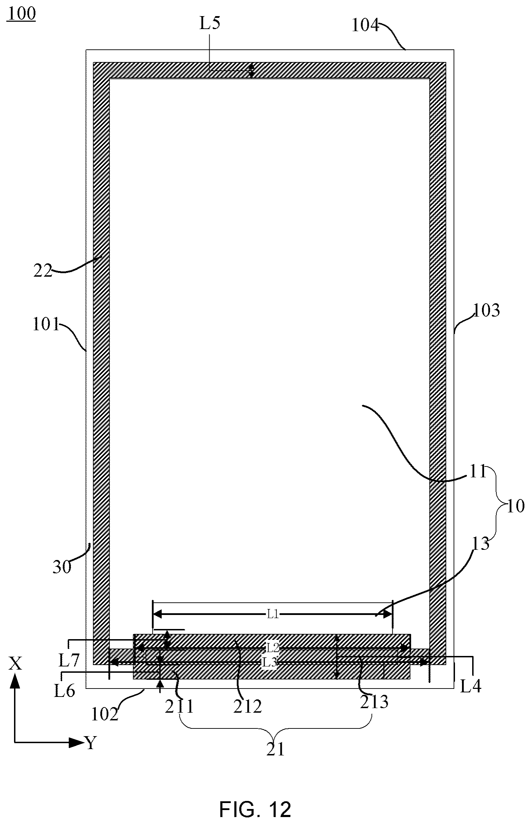

In some embodiments, as shown in FIGS. 11 and 12, a length L2 of the first frame 21 is greater than a length L1 of the bonding portion 13 of the display panel 10, and is less than a length L3 of the lower frame 102; and a portion of the second frame 22 extends to the lower frame 102 to connect the first frame 21.

In some embodiments, as shown in FIG. 13, a length L2 of the first frame 21 is greater than a length L1 of the bonding portion 13 of the display panel 10, and is substantially equal to a length L3 of the lower frame 102; and the second frame 22 is provided only at the left frame 101, the right frame 103 and the upper frame 104, and is connected to the first frame 21 provided at the lower frame 102.

It will be noted that the "L2 and L3 being approximately equal" means that a difference between the length L2 of the first frame 21 (i.e., a dimension of the first frame 21 in the Y direction) and the length L3 of the lower frame 102 (i.e., a dimension of the lower frame 102 in the Y direction) is very small, for example, the difference is within a range of ±5 mm.

In some embodiments, as shown in FIGS. 9 and 11, a width L4 of the first frame 21 (i.e., a dimension of the first frame 21 in the X direction) is equal or substantially equal to a width L5 of the second frame 22 (i.e., a dimension of the second frame 22 in a direction perpendicular to its own length extending direction), which enables the display module 100 to have a relatively uniform width of the frames at various positions.

In some other embodiments, as shown in FIGS. 12 and 13, a width L4 of the first frame 21 is greater than a width L5 of the second frame 22, and the width L5 of the second frame 22 may be equal or substantially equal to a width L6 of the first retaining wall 211 of the first frame 21 (i.e., a dimension of the first retaining wall 211 in the X direction), or equal or substantially equal to a width L7 of the second retaining wall 212 of the first frame 21 (i.e., a dimension of the second retaining wall 212 in the X direction). Since the bending portion 12 and the bonding portion 13 are located at the position of the lower frame 102, the first frame 21 can cover and protect the bending portion 12 more fully by providing the first frame 21 with a relatively large width. Moreover, the width of the second frame 22 is equal to the width of the first retaining wall 211 (or the second retaining wall 212) of the first frame 21, which is convenient for forming the second frame 22 and the first retaining wall 211 (or the second retaining wall 212) under the same process step, that is, the formation of the second frame 22 is compatible with that of the first frame 21, which is conducive to simplifying the process flow of manufacturing the display module.

The structure of the second frame 22 of the display module 100 will be described in detail below.

In some embodiments, as shown in FIGS. 11, 12, and 13, the second frame 22 is of a single-layer structure.

The above "single-layer structure" means that the second frame 22 includes only one film layer structure along a direction perpendicular to the length extending direction of the second frame 22.

In some other embodiments, as shown in FIG. 10, FIG. 10 is a cross-sectional view of the display apparatus 1000 in FIG. 2 taken along the section line I-I. The second frame 22 is of a composite structure, that is, the second frame 22 includes multiple film layer structures along a direction perpendicular to the length extending direction of the second frame 22. The second frame 22 includes a third retaining wall 221, a fourth retaining wall 222 and a second filling portion 223. A first end 221a of the third retaining wall 221 is connected to an edge region of the cover plate 30, a first end 222a of the fourth retaining wall 222 is connected to the display portion 11, and the third retaining wall 221 and the fourth retaining wall 222 have a spacing d3 therebetween. The second filling portion 223 is provided between the third retaining wall 221 and the fourth retaining wall 222 in a filling manner.

It can be understood that in the embodiments of the present disclosure, the third retaining wall 221 and the fourth retaining wall 222 may be formed by a printing process, and the second filling portion 223 may be formed by a printing process or an adhesive pouring process. In order to enable the second filling portion 223 to more fully cover the display portion 11 of the display panel 10 to better protect the display portion 11, a material for forming the second filling portion 223 may be a material with a relatively low viscosity, so that when the second filling portion 223 is formed by printing or pouring adhesive, the material of the second filling portion 223 can flow more easily toward the direction of the cover plate 30 to cover more of the display portion 11.

The third retaining wall 221 and the fourth retaining wall 222 serve as a blocking structure for the second filling portion 223 to prevent the material of the second filling portion 223 from overflowing. In addition, in order to improve the molding rate of the third retaining wall 221 and the fourth retaining wall 222 formed by printing, a material for forming the third retaining wall 221 and a material for forming the fourth retaining wall 222 may be materials with a high viscosity. That is, the viscosity of the material for forming the third retaining wall 221 and the viscosity of the material for forming the fourth retaining wall 222 are greater than the viscosity of the material for forming the second filling portion 223.

As described above, the second frame 22 may be made of a material with a low elasticity modulus. On this basis, for example, the materials for forming the third retaining wall 221, the fourth retaining wall 222, and the second filling portion 223 may be polyimide or epoxy resin.

In some embodiments, the materials for forming the third retaining wall 221, the fourth retaining wall 222 and the second filling portion 223 are the same, but have different viscosities, or the materials for forming the third retaining wall 221, the fourth retaining wall 222 and the second filling portion 223 contain the same compositions. In this case, the third retaining wall 221, the fourth retaining wall 222 and the second filling portion 223 after being cured and molded are in a one-piece structure, that is, the second frame 22 is in a one-piece structure. It can be understood that the "same material" means that the third retaining wall 221, the fourth retaining wall 222 and the second filling portion 223 have a same main material, and different types of other materials or a same type of another material but in different amounts may be mixed in the third retaining wall 221, the fourth retaining wall 222 and the second filling portion 223. For example, adding another material with different amounts into the same main material may enable the second filling portion 223 to have a low viscosity, and the third retaining wall 221 and the fourth retaining wall 222 to have a high viscosity.

On this basis, since the material for forming the second filling portion 223 has a relatively low viscosity, that is, the material for forming the second filling portion 223 has a relatively high fluidity, after the material for forming the second filling portion 223 provided between the third retaining wall 221 and the fourth retaining wall 222 is cured, a surface of the second filling portion 223 on a side thereof away from the cover plate 30 partially produces a slight recess in a direction toward the cover plate 30, that is, the surface of the second filling portion 223 on a side thereof away from the cover plate 30 is not flat.

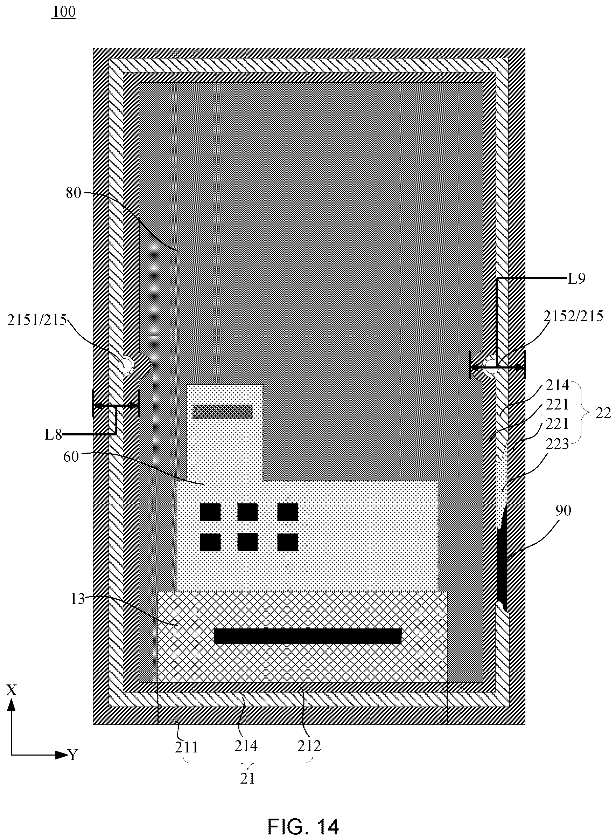

In some embodiments, as shown in FIG. 14, the first retaining wall 211 is connected to the third retaining wall 221, and the second retaining wall 212 is connected to the fourth retaining wall 222; and the top cover 214 is provided on ends, away from the cover plate 30, of the first retaining wall 211, the second retaining wall 212, the third retaining wall 221, and the fourth retaining wall 222. The top cover 214 is provided therein with a plurality of through holes 215.

The top cover 214, the first retaining wall 211, the second retaining wall 212, the third retaining wall 221, and the fourth retaining wall 222 form an accommodation space enclosed thereby, and the accommodation space is filled with the first filling portion 213 and the second filling portion 223.

For example, the through holes 215 include at least one pouring hole 2151 and at least one exhaust hole 2152, that is, the top cover 214 is provided therein with both the pouring hole 2151 and the exhaust hole 2152. In the top cover 214, the pouring hole 2151 and the exhaust hole 2152 may have an equal number or different numbers. For example, in the top cover 214, both the pouring hole 2151 and the exhaust hole 2152 may have the number of 1, 2 or 3; alternatively, in the top cover 214, the pouring hole 2151 may have the number of 1, and the exhaust hole 2152 may have the number of 2.

For example, the material for forming the first retaining wall 211 and the material for forming the third retaining wall 221 may be the same, and the material for forming the second retaining wall 212 and the material for forming the fourth retaining wall 222 may be the same; and in forming the first retaining wall 211, the second retaining wall 212, the third retaining wall 221, and the fourth retaining wall 222 by a printing process, the first retaining wall 211 and the third retaining wall 221 may be formed synchronously, and the second retaining wall 212 and the fourth retaining wall 222 may also be formed synchronously. In this way, the manufacturing steps may be simplified, which is conducive to improving the manufacturing efficiency of the first frame 21 and the second frame 22.

For example, the material for forming the first filling portion 213 and the material for forming the second filling portion 223 may be the same filling material, and the first filling portion 213 and the second filling portion 223 are formed simultaneously in the accommodation space enclosed by the top cover 214, the first retaining wall 211, the second retaining wall 212, the third retaining wall 221, and the fourth retaining wall 222. In this way, the manufacturing steps may be simplified, which is conducive to improving the manufacturing efficiency of the first frame 21 and the second frame 22.

In some embodiments, in a case where the top cover 214 includes a support layer 2141 and a body layer 2142, if the materials for forming the first retaining wall 211, the second retaining wall 212, the third retaining wall 221, the fourth retaining wall 222, the first filling portion 213, the second filling portion 223, and the body layer 2142 of the top cover 214 are the same, the first retaining wall 211, the second retaining wall 212, the third retaining wall 221, the fourth retaining wall 222, the first filling portion 213, the second filling portion 223, and the body layer 2142 of the top cover 214 after being molded are in a one-piece structure, and the support layer 2141 is embedded in the one-piece structure formed by the first retaining wall 211, the second retaining wall 212, the third retaining wall 221, the fourth retaining wall 222, the first filling portion 213, the second filling portion 223, and the body layer 2142 of the top cover 214.

For example, as shown in FIG. 14, a width L9 of a portion of the second frame 22 provided with the through hole 215 may be greater than a width L8 of a portion of the second frame 22 not provided with the through hole 215. In this way, in an aspect, it is ensured that the through hole 215 has a sufficient size for pouring adhesive or vacuuming, and in another aspect, it may be ensured that the portion of the second frame 22 not provided with the through hole 215 has a small width, thereby implementing the narrow frame of the display apparatus 1000.

It can be understood that in a case where the top cover 214, the first retaining wall 211, the second retaining wall 212, the third retaining wall 221, and the fourth retaining wall 222 form the accommodation space enclosed thereby, a portion of the top cover 214 corresponding to the first frame 21 may also be provided therein with a through hole 215. In a case where the through hole 215 is provided in the portion of the top cover 214 corresponding to the first frame 21, a width of a portion of the first frame 21 where the through hole 215 is located may be greater than a width of a portion of the first frame 21 not provided with the through hole 215. In this way, in an aspect, it is ensured that the through hole 215 has a sufficient size for pouring adhesive or vacuuming, and in another aspect, it may be ensured that the portion of the first frame 21 not provided with the through hole 215 has a small width, thereby implementing the narrow frame of the display apparatus 1000.

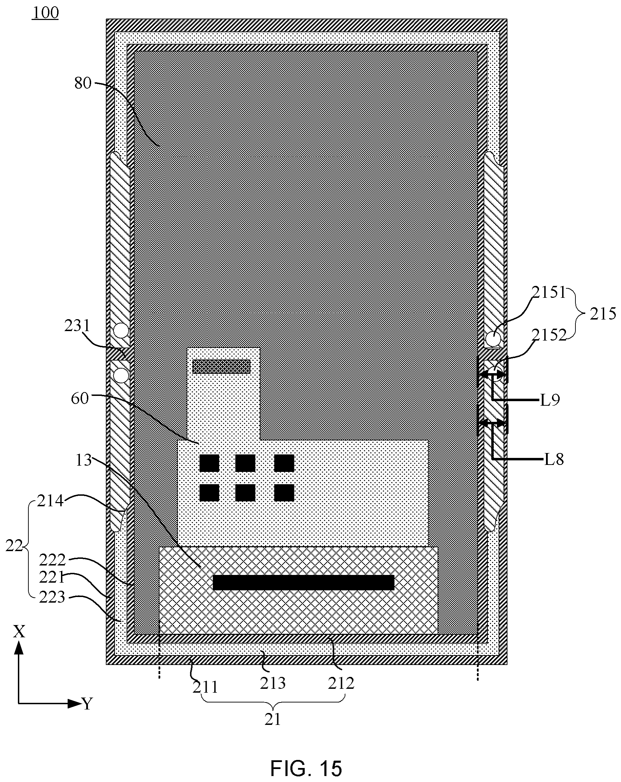

Considering that due to the long flow path of the adhesive material, if the first filling portion 213 and/or the second filling portion 223 are formed by pouring the adhesive material at one time, the adhesive material may fail to sufficiently fill the accommodation space enclosed by the top cover 214, the first retaining wall 211, the second retaining wall 212, the third retaining wall 221, and the fourth retaining wall 222, in some embodiments, as shown in FIG. 15, the display module 100 further includes at least one fifth retaining wall 231. The fifth retaining wall 231 is disposed within the accommodation space enclosed by the top cover 214, the first retaining wall 211, the second retaining wall 212, the third retaining wall 221, and the fourth retaining wall 222, dividing the accommodation space into a plurality of accommodation sub-spaces. By providing the fifth retaining wall 231 to divide the accommodation space into a plurality of accommodation sub-spaces, each of the accommodation sub-spaces may have the first filling portion 213 and/or the second filling portion 223 formed therein, thereby shortening the flow path of the pouring of the adhesive material, facilitating the adhesive material to fully fill each of the accommodation sub-spaces, and conducive to improving the yield of the first frame 21 and the second frame 22.

The fifth retaining wall 231 may be made of the same material as the first retaining wall 211, the second retaining wall 212, the third retaining wall 221, or the fourth retaining wall 222, allowing them to be formed simultaneously, which is conducive to simplifying the manufacturing steps and reducing the manufacturing difficulty.

In a case where the accommodation space enclosed by the top cover 214, the first retaining wall 211, the second retaining wall 212, the third retaining wall 221, and the fourth retaining wall 222 are divided into a plurality of accommodation sub-spaces, a region, corresponding to each of the accommodation sub-spaces, of the top cover 214 is provided therein with multiple ones of the plurality of through holes 215, and the through holes 215 corresponding to each of the accommodation sub-spaces include at least one pouring hole 2151 and at least one exhaust hole 2152.

The above "the through holes 215 corresponding to each of the accommodation sub-spaces including at least one pouring hole 2151 and at least one exhaust hole 2152" means that the through holes 215 corresponding to each of the accommodation sub-spaces may include one pouring hole 2151 and one exhaust hole 2152, or the through holes 215 corresponding to each of the accommodation sub-spaces may include multiple pouring holes 2151 and multiple exhaust holes 2152; and means that in the through holes 215, pouring hole(s) 2151 and exhaust hole(s) 2152 that correspond each of the accommodation sub-spaces may have the same number or different numbers.

The method for manufacturing the display module 100 described above will be described in detail below.

As shown in FIGS. 16, 17, 18 and 20, FIG. 16 is a flowchart of a method for manufacturing a display module 100 in some embodiments of the present disclosure, and

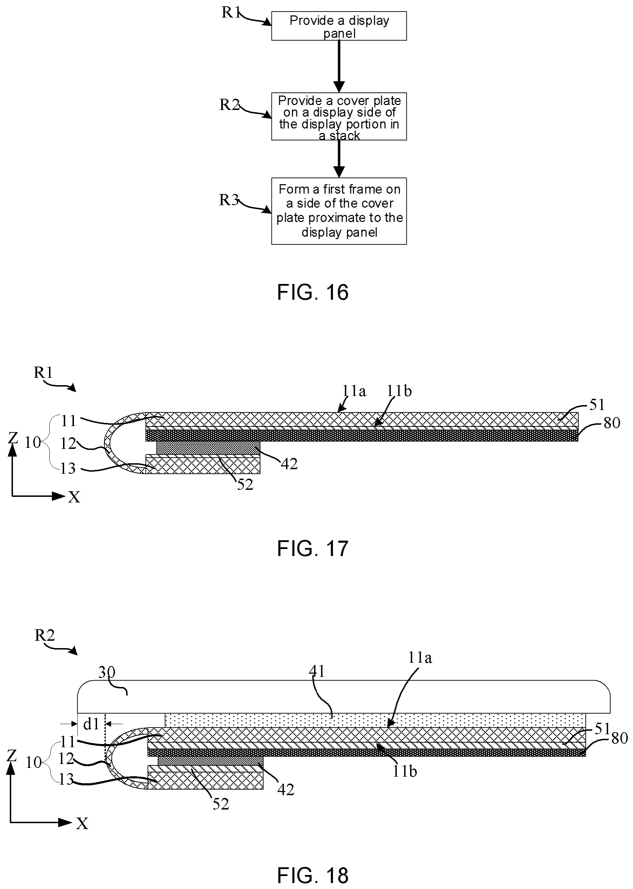

FIGS. 17, 18 and 20 are structural diagrams corresponding to respective steps in the method for manufacturing the display module 100 in accordance with FIG. 16. The method for manufacturing the display module 100 includes the following steps R1 to R3.

In step R1, as shown in FIG. 17, a display panel 10 is provided, where the display panel 10 includes a display portion 11, a bending portion 12 and a bonding portion 13 that are connected to each other in sequence, and the bending portion 12 is bent to enable the bonding portion 13 to be located on a non-display side 11b of the display portion 11.

In step R2, as shown in FIG. 18, a cover plate 30 is provided on a display side 11a of the display portion 11 in a stack, a boundary of the cover plate 30 is farther away from the display portion 11 than a boundary of the bending portion 12 farthest from the display portion 11. That is, an orthographic projection of the boundary of the bending portion 12 farthest from the display portion 11 on the cover plate 30 lies within the cover plate 30, and has a distance d1 from the boundary of the cover plate 30

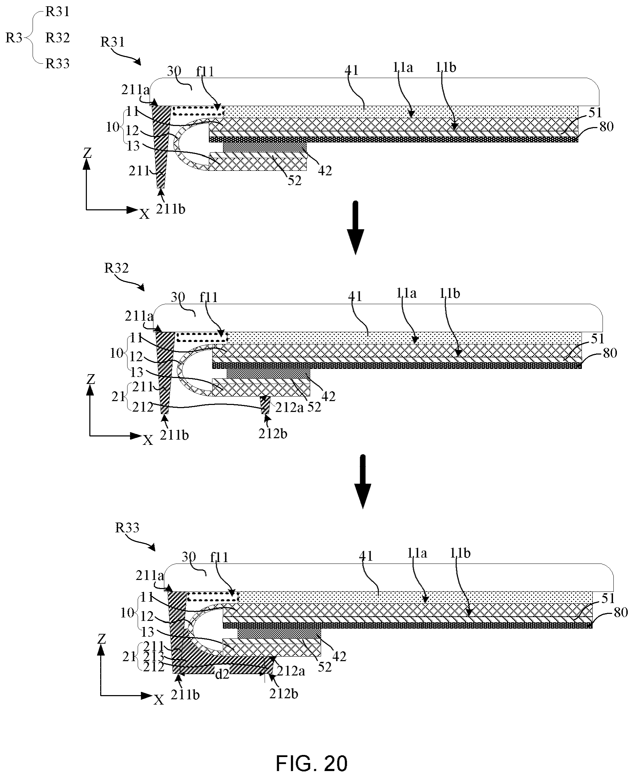

In step R3, as shown in FIG. 20, a first frame 21 is formed on a side of the cover plate 30 proximate to the display panel 10, the first frame 21 extending along a side edge of the cover plate 30 corresponding to the bonding portion 13.

The above steps of forming the first frame 21 will be described in detail below.

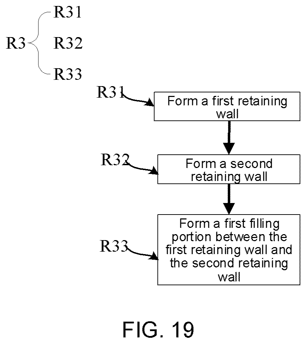

As shown in FIGS. 19 and 20, FIG. 19 is a flowchart of the step of forming the first frame 21, in accordance with some embodiments of the present disclosure, and FIG. 20 is a structural diagram corresponding to respective steps in the step of forming the first frame 21 in accordance with FIG. 19. The step of forming the first frame 21 includes the following steps R31 to R32.

In step R31, a first retaining wall 211 is formed on an edge region of the cover plate 30 by a printing process.

In step R32, a second retaining wall 212 is formed on a side of the bonding portion 13 away from the cover plate 30 by a printing process, the second retaining wall 212 and the first retaining wall 211 having a spacing d2 therebetween.

In step R33, a first filling portion 213 is formed between the first retaining wall 211 and the second retaining wall 212 by a printing process or an adhesive pouring process.

Here, a viscosity of a material for forming the first retaining wall 211 and a viscosity of a material for forming the second retaining wall 212 are greater than a viscosity of a material for forming the first filling portion 213. In order to enable the first filling portion 213 to more fully cover the bending portion 12 to better protect the bending portion 12, the material for forming the first filling portion 213 may be a material with a relatively high fluidity, i.e., using the material with a relatively low viscosity, so that when the first filling portion 213 is formed by printing or pouring adhesive, the material of the first filling portion 213 can flow more easily toward the direction of the cover plate 30 to cover more of the bending portion 12.

The first retaining wall 211 and the second retaining wall 212 may serve as a blocking structure for the first filling portion 213 to prevent the material of the first filling portion 213 from overflowing. In addition, in order to improve the molding rate of the first retaining wall 211 and the second retaining wall 212 formed by printing, the material for forming the first retaining wall 211 and the material for forming the second retaining wall 212 may be materials with a high viscosity.

The method for forming the first frame 21 is as follows: firstly, the first retaining wall 211 and the second retaining wall 212 are formed respectively by a printing process, and then the first filling portion 213 is formed between the first retaining wall 211 and the second retaining wall 212 by a printing process or an adhesive pouring process. Compared with forming the first frame 21 by an injection molding process, no mold is required in the process of forming the first frame 21, in this way, in an aspect, it may avoid the first frame 21 from being easily defective during the demolding process, and in another aspect, since different molds are used for display modules 100 with different sizes when forming first frames 21 by the injection molding process, and the corresponding molds need to be made respectively, the method of forming the first frame 21 in the embodiments of the present disclosure may reduce the manufacturing cost of the first frame 21 to further reduce the manufacturing cost of the display module 100.

For example, the materials for forming the first retaining wall 211, the second retaining wall 212 and the first filling portion 213 may be polyimide or epoxy resin.

For example, the above printing process may be a 3D printing process.

For example, in a case where the first filling portion 213 is formed between the first retaining wall 211 and the second retaining wall 212 by a printing process or an adhesive pouring process, after the material for forming the first filling portion 213 enters a space between the first retaining wall 211 and the second retaining wall 212, an ultraviolet curing may be used to accelerate the molding of the first filling portion 213.

In some embodiments, as shown in FIG. 5, since the material for forming the first filling portion 213 has a relatively low viscosity, that is, the material for forming the first filling portion 213 has a relatively high fluidity, after the material for forming the first filling portion 213 provided between the first retaining wall 211 and the second retaining wall 212 is cured, a first surface 213a thereof (i.e., a surface of the first filling portion 213 on a side thereof away from the cover plate 30) partially produces a slight recess in a direction toward the cover plate 30, that is, the surface of the first filling portion 213 on a side thereof away from the cover plate 30 is not flat.

As shown in FIG. 20, in the above step R33, when the first filling portion 213 is formed between the first retaining wall 211 and the second retaining wall 212 by a printing process or an adhesive pouring process, due to the relatively small volume of a region between the cover plate 30 and the bending portion 12 (i.e., the region f11 enclosed by the dashed box in FIG. 20), the material for forming the first filling portion 213 may be difficult to enter the region f11 between the cover plate 30 and the bending portion 12.

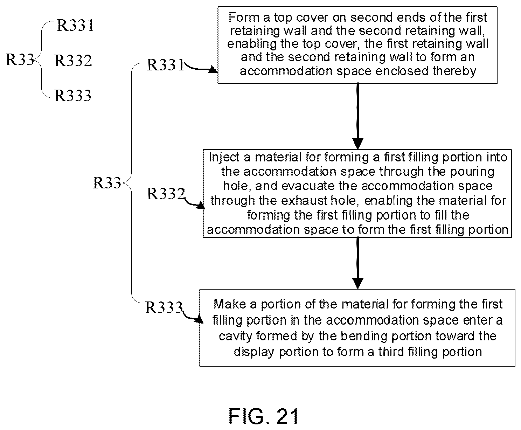

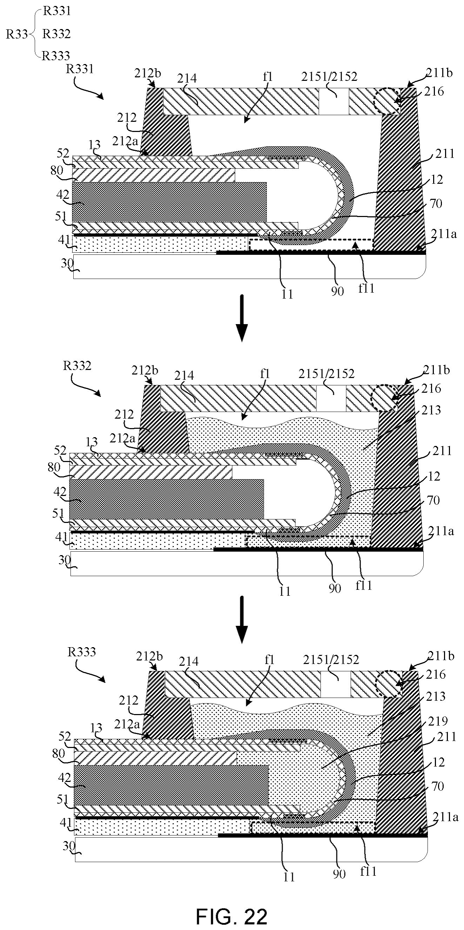

**In** light of this, in some embodiments, as shown in FIGS. 21 and 22, FIG. 21 is a flowchart of step R33 of forming the first frame 21, in accordance with some embodiments of the present disclosure, and FIG. 22 is a structural diagram corresponding to respective steps in step R33 of forming the first frame 21 in accordance with FIG. 21. **In** the above steps of forming the first frame 21, step R33 after step R32 specifically includes the following steps R331 and R332.

**In** step R331, a top cover 214 is formed on a second end 211b of the first retaining wall 211 (i.e., an end of the first retaining wall 211 away from the cover plate 30) and a second end 212b of the second retaining wall 212 (i.e., an end of the second retaining wall 212 away from the cover plate 30), enabling the top cover 214, the first retaining wall 211 and the second retaining wall 212 to form an accommodation space f1 enclosed thereby.

Here, the top cover 214 is provided therein with a plurality of through holes 215, and the plurality of through holes 215 include at least one pouring hole 2151 and at least one exhaust hole 2152.

**In** step R332, a material (adhesive material) for forming a first filling portion 213 is injected into the accommodation space f1 through the pouring hole 2151 by an adhesive pouring process, and the accommodation space f1 is evacuated through the exhaust hole 2152, enabling the material (adhesive material) for forming the first filling portion 213 to fill the accommodation space f1 to form the first filling portion 213.

After the material for forming the first filling portion 213 enters the accommodation space f1 through the pouring hole 2151, the accommodation space f1 is evacuated through the exhaust hole 2152, which is beneficial for the material for forming the first filling portion 213 to flow toward a side proximate to the cover plate 30, and flow to a space between the cover plate 30 and the bending portion 12, that is, a region f11 enclosed by the dotted box in FIG. 22, which may increase the contact area of the first filling portion 213 and the bending portion 12, which is conducive to further protecting the bending portion 12 of the display panel 10 and improving the crush-resistance strength of the bending portion 12 of the display panel 10.

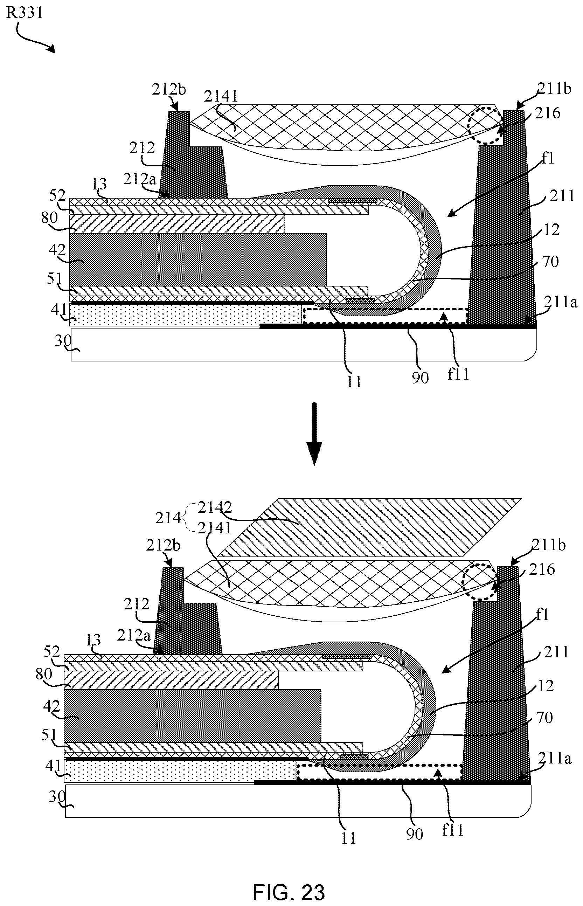

For example, as shown in FIG. 23, the above step of forming the top cover 214 includes: forming a support layer 2141 on a second end 211b of the first retaining wall 211 (i.e., an end of the first retaining wall 211 away from the cover plate 30) and a second end 212b of the second retaining wall 212 (i.e., an end of the second retaining wall 212 away from the cover plate 30), and forming a body layer 2142 on a side of the support layer 2141 away from the cover plate 30 by a printing process.

The support layer 2141 can play a supporting role in the process of forming the body layer 2142 by the printing process, which not only facilitates the molding of the body layer 2142, but also enables the body layer 2142 to have a flat surface after being molded.

For example, when forming the top cover 214 by the steps described above, hole cores having the same diameter as that of the pouring hole 2151 and the exhaust hole 2152 may be reserved before forming the support layer 2141 and the body layer 2142, and the hole cores may be pulled out after the top cover 214 has been formed to obtain the pouring hole 2151 and the exhaust hole 2152. Here, a material of the hole cores may be a metal, such as aluminum.

For example, as shown in FIG. 23, when forming the first retaining wall 211 and the second retaining wall 212 by the printing process, ends of the first retaining wall 211 and the second retaining wall 212 away from the cover plate 30, i.e., the second end 211b of the first retaining wall 211 and the second end 212b of the second retaining wall 212, are each formed with a notch 216 thereon. The notches 216 may not only be used to hold the support layer 2141 when forming the support layer 2141, but may also act as a barrier to avoid a material for forming the body layer 2142 from overflowing when forming the body layer 2142 by the printing process.

For example, a material of the support layer 2141 may be a metal mesh.

For example, the material for forming the body layer 2142 may be a resin, such as a photosensitive resin.

In some embodiments, continuing to refer to FIGS. 21 and 22, the above step R33 further includes step R333, in which a portion of the material for forming the first filling portion 213 in the accommodation space f1 enters a cavity formed by the bending portion 12 toward the display portion 11, to form a third filling portion 219.

It can be understood that when the third filling portion 219 is formed through the above step R333, a material for forming the third filling portion 219 is the same as the material for forming the first filling portion 213. The steps R333 and R332 are performed simultaneously.

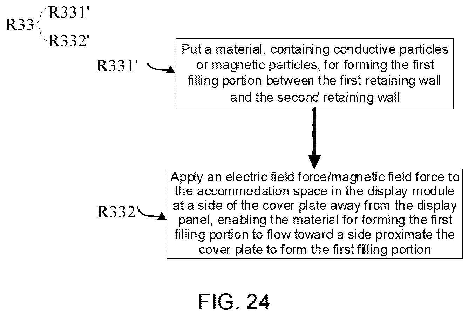

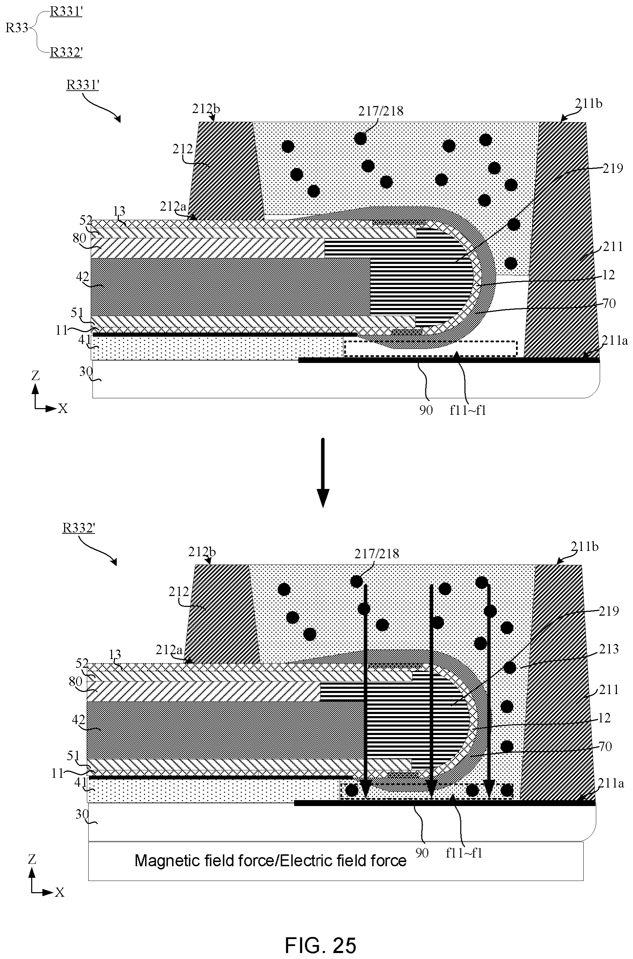

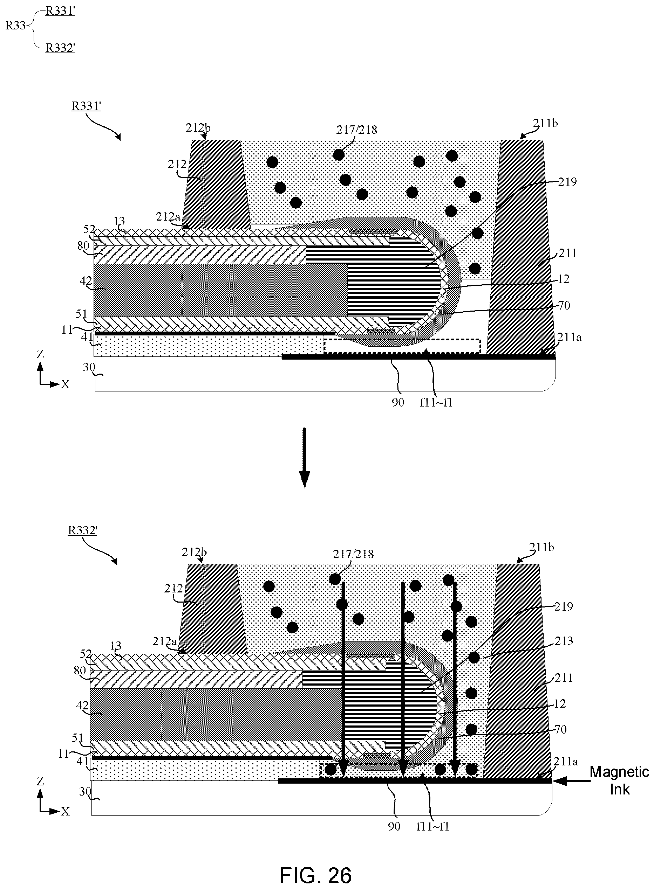

In some other embodiments, as shown in FIGS. 24, 25 and 26, FIG. 24 is a flowchart of step R33 of forming the first frame 21, in accordance with some embodiments of the present disclosure, and FIGS. 25 and 26 are each a structural diagram corresponding to respective steps in step R33 of forming the first frame 21 in accordance with FIG. 24. In the above steps of forming the first frame 21, step R33 after step R32 specifically includes the following steps R331' and R332'.

In step R331', as shown in FIG. 25 or 26, a material (i.e., an adhesive material), containing conductive particles 218 or magnetic particles 217, for forming the first filling portion 213 is put between the first retaining wall 211 and the second retaining wall 212.

In step R332', as shown in FIG. 25, an electric field force or a magnetic field force is applied to the accommodation space f1 in the display module 100 at a side of the cover plate 30 away from the display panel 10. That is to say, in a case where the material for forming the first filling portion 213 contains conductive particles 218, the electric field force is applied to the accommodation space f1 in the display module 100 at the side of the cover plate 30 away from the display panel 10; and in a case where the material for forming the first filling portion 213 contains magnetic particles 217, a magnetic field force is applied to the accommodation space f1 in the display module 100 at the side of the cover plate 30 away from the display panel 10. In this way, the material (i.e., the adhesive material), containing conductive particles 218 or magnetic particles 217, for forming the first filling portion 213 is made to flow toward a side proximate to the cover plate 30 (i.e., in a direction of the black arrow in FIG. 25), and flow to a space between the cover plate 30 and the bending portion 12, that is, a region f11 enclosed by the dotted box in FIG. 25, which may increase the contact area of the first filling portion 213 and the bending portion 12, which is conducive to further protecting the bending portion 12 of the display panel 10 and improving the crush-resistance strength of the bending portion 12 of the display panel 10.

Alternatively, as shown in FIG. 26, in a case where the material for forming the first filling portion 213 contains magnetic particles 217, a magnetic ink layer may serve as the ink layer 90 that is on an edge region of the cover plate 30 on a side thereof proximate to the display panel 10. In this way, the material (i.e., the adhesive material), containing magnetic particles 217, for forming the first filling portion 213 is made flow toward a direction proximate to the magnetic ink layer, and flow to a space between the cover plate 30 and the bending portion 12, that is, a region f11 enclosed by the dotted box in FIG. 26, so that the formed first filling portion 213 contacts the ink layer 90, and a part of the first filling portion 213 extends between the bending portion 12 and the ink layer 90, which may increase the contact area of the first filling portion 213 and the bending portion 12, which is conducive to further protecting the bending portion 12 of the display panel 10 and improving the crush-resistance strength of the bending portion 12 of the display panel 10.

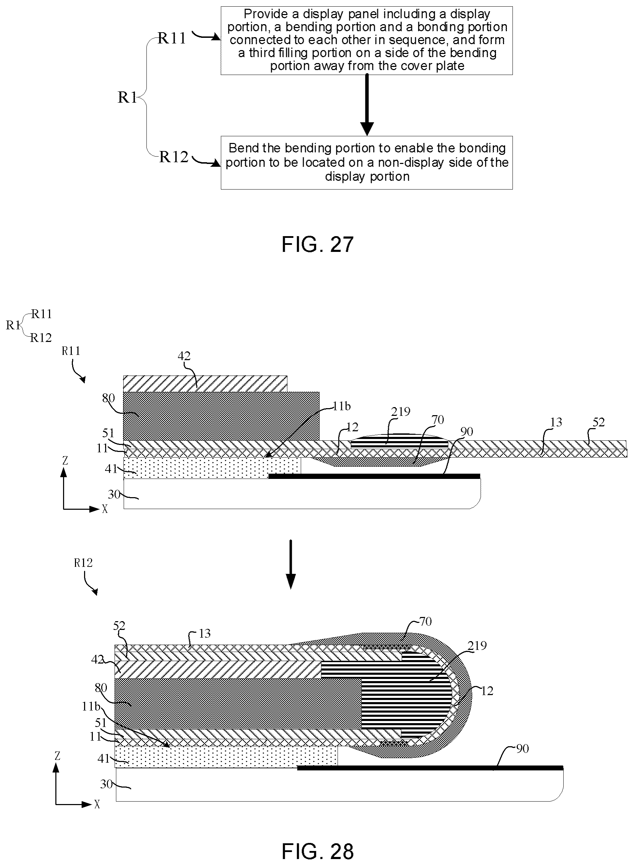

In some embodiments, step R1 in the above method for manufacturing the display module 100 further includes forming a third filling portion 219. As shown in FIGS. 27 and 28, FIG. 27 is a flowchart of step R1 in the method for manufacturing the display module 100 in some embodiments of the present disclosure, and FIG. 28 is a structural diagram corresponding to respective steps in step R1 in the method for manufacturing the display module 100 in accordance with FIG. 27. The above step R1 comprises the following steps R11 and R12.

In step R11, a display panel 10 is provided, where the display panel 10 includes a display portion 11, a bending portion 12 and a bonding portion 13 that are connected to each other in sequence; and a third filling portion 219 is formed on a side of the bending portion 12 away from the cover plate 30.

In step R12, the bending portion 12 is bent to enable the bonding portion 13 to be located on a non-display side 11b of the display portion 11.

It can be understood that for the third filling portion 219 formed by the above step R1, since the third filling portion 219 is formed before the first filling portion 213, that is, the third filling portion 219 and the first filling portion 213 are not formed synchronously, the material for forming the third filling portion 219 may be different or the same as the material for forming the first filling portion 213.

For example, the material for forming the third filling portion 219 may be polyimide or epoxy resin.

For example, the third filling portion 219 may be formed by an adhesive pouring process.

In some embodiments, the above method for manufacturing the display module 100 further includes step R4, in which a second frame 22 is formed on a side of the cover plate 30 proximate to the display panel 10, with the second frame 22 being connected to the first frame 21 to form a box-frame surrounding the display panel 10. The step of forming the second frame 22 will be described in detail below.

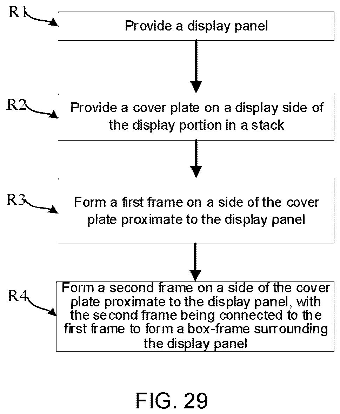

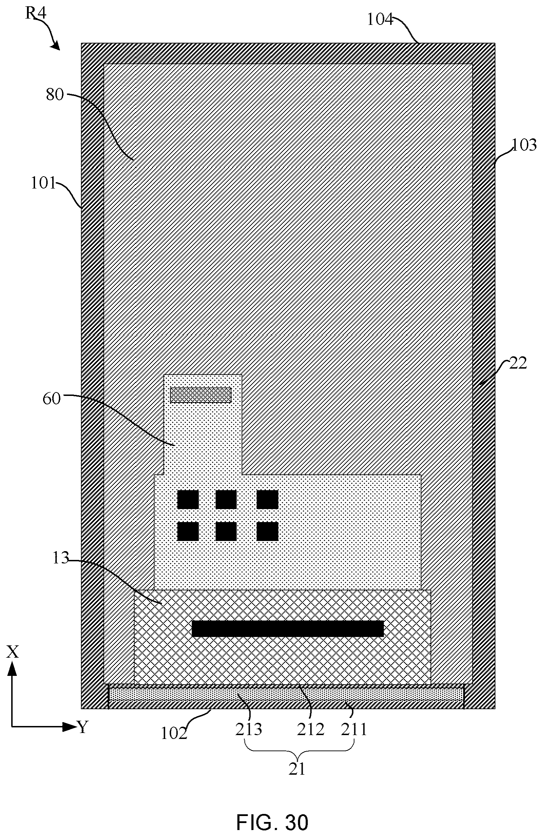

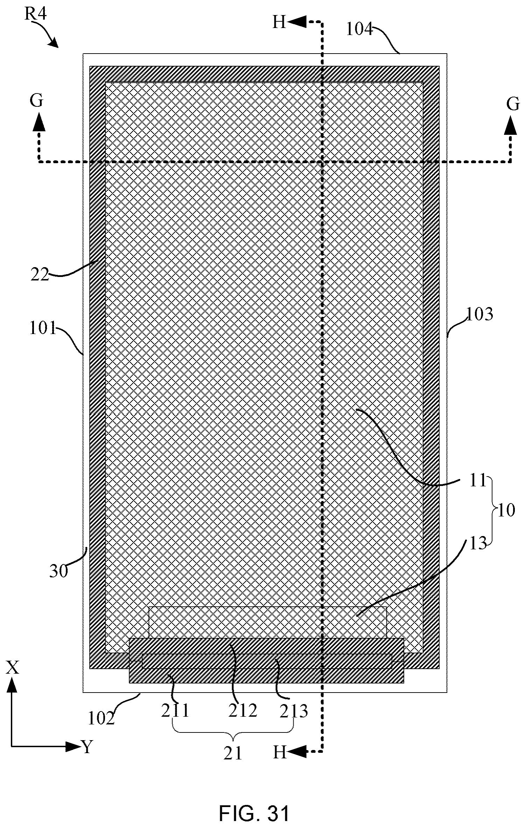

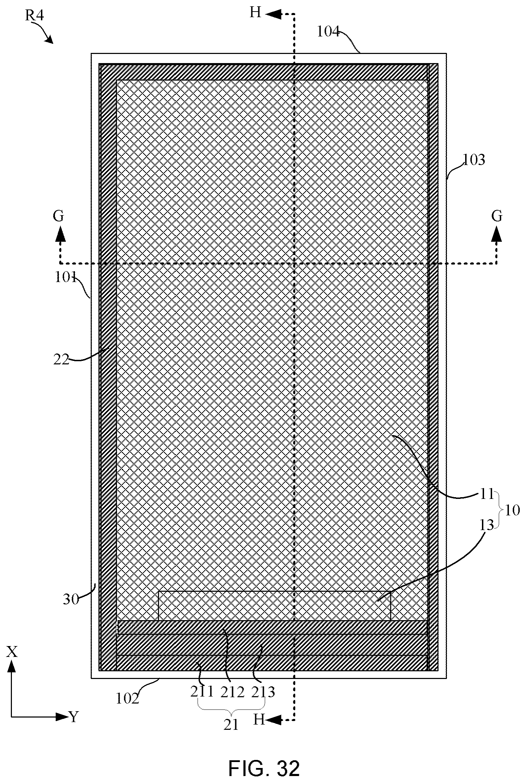

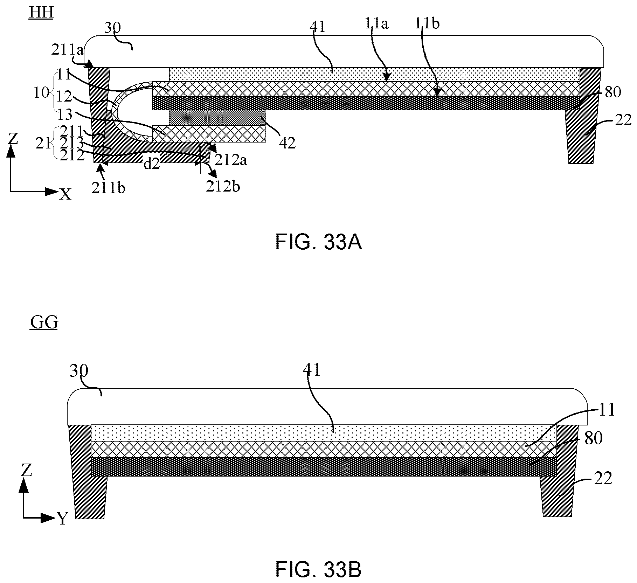

In some embodiments, the second frame 22 is of a single-layer structure. The second frame 22 may be formed separately before forming the first frame 21 or after forming the first frame 21. As shown in FIGS. 29 to 33B, FIG. 29 is a flowchart of a method for manufacturing the display module 100 in some embodiments of the present disclosure, and FIGS. 30 to 32 are each a structural diagram corresponding the method for manufacturing the display module 100 in accordance with FIG. 29. FIG. 33A is a cross-sectional view taken along the section line H-H of FIG. 31 or 32, and FIG. 33B is a cross-sectional view taken along the section line G-G of FIG. 31 or 32. The cross-sectional structure of the formed first frame 21 and the formed second frame 22 can be illustrated in FIG. 33A, and the cross-sectional structure of the formed second frame 22 can be illustrated in FIG. 33B. Here, FIGS. 30 to 32 are distinguished from each other by different shaped first frames 21 and different shaped second frames 22, as described with reference to the description with respect to FIGS. 11 to 13, which will not be repeated herein.

It will be noted that FIGS. 29 to 33B are illustrated by an example that the second frame 22 is formed separately after the first frame 21 is formed, but the order in which the first frame 21 is formed and the second frame 22 is formed in the present disclosure is not limited to this.

For example, a printing process may be used to form the second frame 22 on a side of the cover plate 30 proximate to the display panel 10, such as a 3D printing process. Compared with forming the second frame 22 by an injection molding process, no mold is required in the process of forming the second frame 22 by the printing process, in this way, in an aspect, it may avoid the second frame 22 from being easily defective during the demolding process, and in another aspect, since different molds are used for display modules 100 with different sizes when forming second frames 22 by the injection molding process, and the corresponding molds need to be made respectively, the method of forming the second frame 22 by the printing process may reduce the manufacturing cost of the second frame 22 to further reduce the manufacturing cost of the display module 100.

For example, a viscosity of the material for forming the second frame 22 is greater than the viscosity of the material for forming the first filling portion 213, making it easy to form the second frame 22 when forming the second frame 22 by the printing process, which is beneficial for improving the molding rate of the second frame 22.

For example, the material for forming the second frame 22 may be polyimide or epoxy resin.

For example, the material for forming the second frame 22 may be the same material as the material for forming the first retaining wall 211 or the material for forming the second retaining wall 212, or may be different from them.

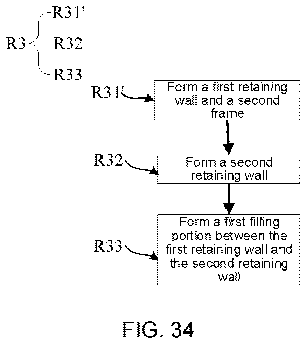

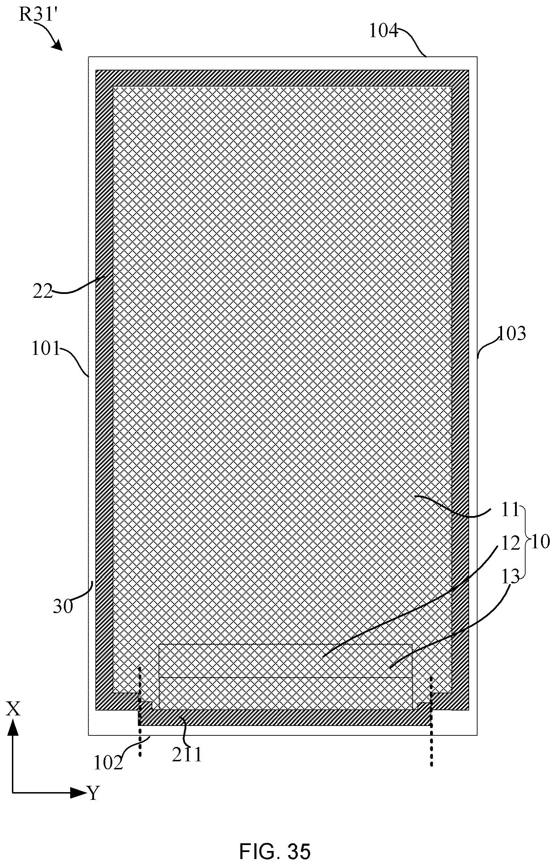

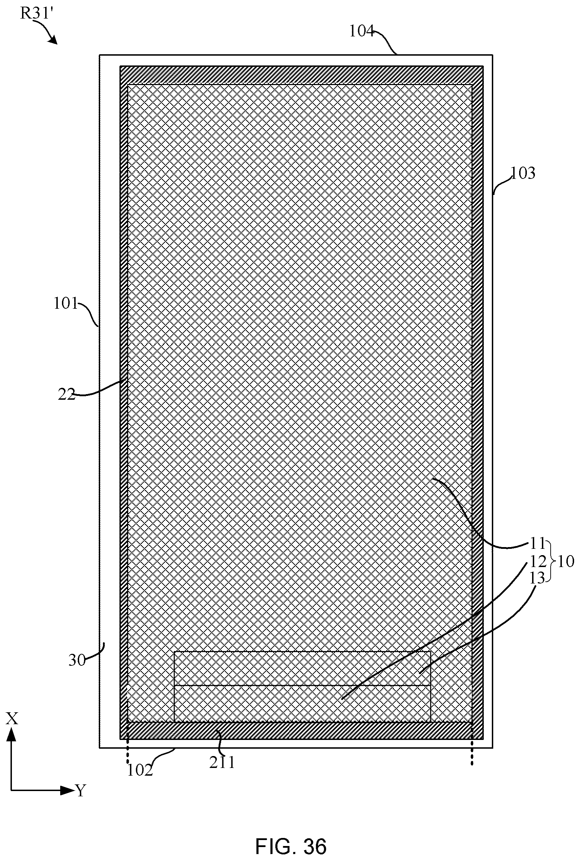

In some embodiments, in a case where the second frame 22 is of a single-layer structure, the second frame 22 may be formed with the first retaining wall 211 of the first frame 21 synchronously, or formed with the second retaining wall 212 of the first frame 21 synchronously. FIGS. 34, 35 and 36 are illustrated by an example that the second frame 22 and the first retaining wall 211 are formed synchronously. As shown in FIGS. 34, 35 and 36, FIG. 34 is a flowchart of step R3 of forming the first retaining wall 211 and the second frame 22 synchronously in some embodiments of the present disclosure, and FIGS. 35 and 36 are each a structural diagram corresponding to step R3 of forming the first retaining wall 211 and the second frame 22 synchronously, in accordance with FIG. 34. It will be noted that the dotted lines along the X direction in FIGS. 35 and 36 refer to the demarcation lines between the first retaining wall 211 and the second frame 22. The difference between FIG. 30 and FIG. 32 is that there are different shaped first retaining walls 211 and different shaped second frames 22, as described with reference to the description with respect to FIGS. 12 and 13, which will not be repeated herein.

In step R31', a first retaining wall 211 and a second frame 22 are formed on an edge region of the cover plate 30 by a printing process.

The first retaining wall 211 and a second frame 22 are formed synchronously by a printing process, which may simplify the manufacturing steps and help improve the manufacturing efficiency of the first frame 21 and the second frame 22.

It can be understood that since the first retaining wall 211 and the second frame 22 are formed simultaneously, the material for forming the first retaining wall 211 is the same as the material for forming the second frame 22, and the first retaining wall 211 and the second frame 22 are of a one-piece structure with no distinct border therebetween.

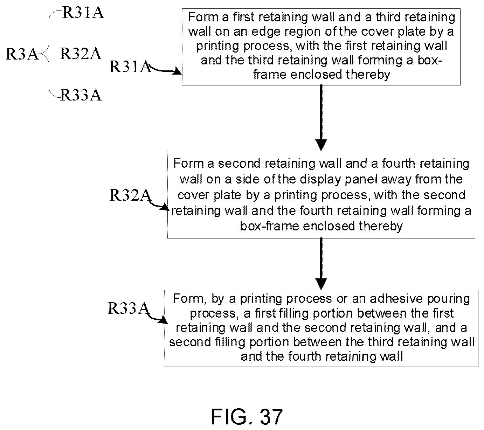

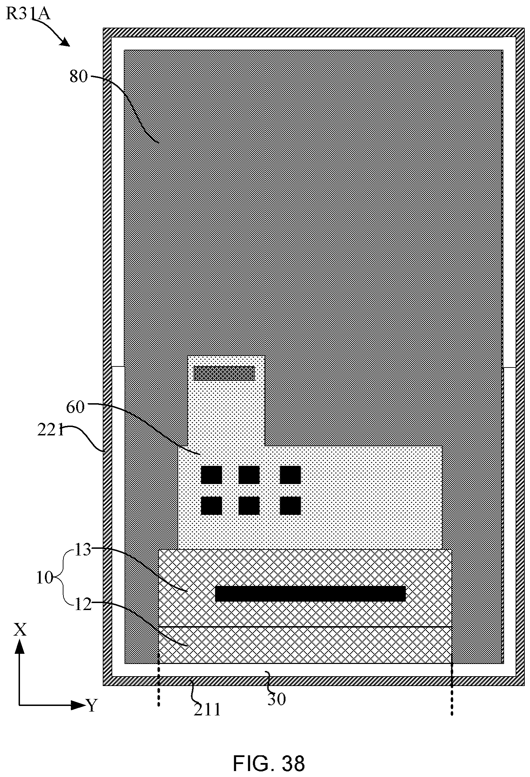

In some other embodiments, the second frame 22 is of a composite structure. The second frame 22 may be formed separately before forming the first frame 21 or after forming the first frame 21, or it may be formed synchronously with the first frame 21. The following description is made by an example that the second frame 22 is formed synchronously with the first frame 21, but the order in which the first frame 21 is formed and the second frame 22 is formed in the present disclosure is not limited to this. As shown in FIGS. 37 to 40, FIG. 37 is a flowchart of step R3A of forming the first frame 21 and the second frame 22 synchronously in some embodiments of the present disclosure, and FIGS. 38 to 40 are each a structural diagram corresponding to respective steps in step R3A of forming the first frame 21 and the second frame 22 synchronously in the method for manufacturing the display module 100 in accordance with FIG. 37.

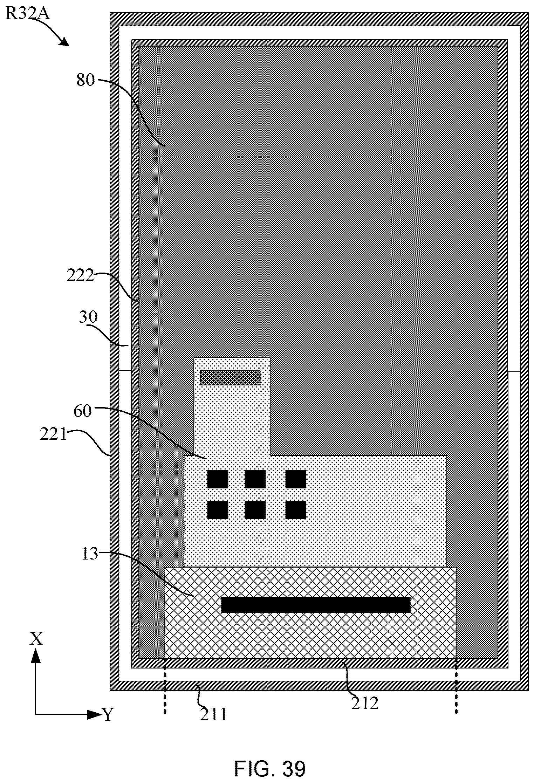

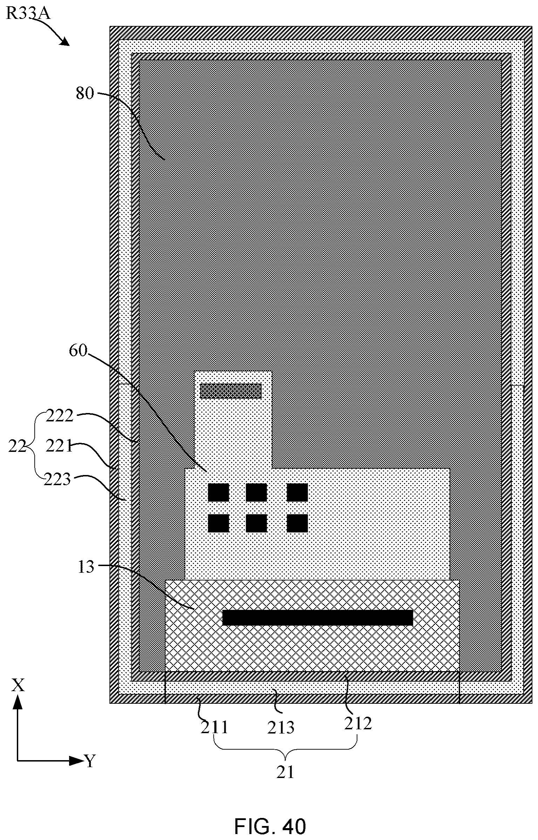

It will be noted that the dashed lines extending in the X direction in FIG. 38 refer to the demarcation lines between the first retaining wall 211 and the third retaining wall 221, the dashed lines extending in the X direction in FIG. 39 refer to the demarcation lines between the first retaining wall 211 and the third retaining wall 221, as well as the demarcation lines between the second retaining wall 212 and the fourth retaining wall 222, and the dashed lines extending in the X direction in FIG. 40 refer to the demarcation lines between the first frame 21 and the second dividing line of the frame 22.

The step R3A of forming the first frame 21 and the second frame 22 synchronously includes the following steps R31A to R33A.

In step R31A, as shown in FIG. 38, a first retaining wall 211 and a third retaining wall 221 are formed on an edge region of the cover plate 30 by a printing process, with the first retaining wall 211 and the third retaining wall 221 forming a box-frame enclosed thereby.

In step R32A, as shown in FIG. 39, a second retaining wall 212 and a fourth retaining wall 222 are formed on a side of the display panel 10 away from the cover plate 30 by a printing process, with the second retaining wall 212 and the fourth retaining wall 222 forming a box-frame enclosed thereby.

In step R33A: as shown in FIG. 40, by a printing process or an adhesive pouring process, a first filling portion 213 is formed between the first retaining wall 211 and the second retaining wall 212, and a second filling portion 223 is formed between the third retaining wall 221 and the fourth retaining wall 222.

**It** will be understood that since the first retaining wall 211 and the third retaining wall 221 are formed synchronously, the second retaining wall 212 and the fourth retaining wall 222 are formed synchronously, and the first filling portion 213 and the second filling portion 223 are formed synchronously, the material for forming the first retaining wall 211 and the material for forming the third retaining wall 221 may be the same, the material for forming the second retaining wall 212 and the material for forming the fourth retaining wall 222 may be the same, and the material for forming the first filling portion 213 and the material for forming the second filling portion 223 may also be the same. **In** addition, the first retaining wall 211 and the third retaining wall 221 may be of a one-piece structure, the second retaining wall 212 and the fourth retaining wall 222 may be of a one-piece structure, and the first filling portion 213 and the second filling portion 223 may also be of a one-piece structure, that is, there is no distinct border between the two in any of the one-piece structure as described.

Through the above steps S31A to S33A, the first frame 21 and the second frame 22 are formed synchronously, thereby simplifying the manufacturing steps and facilitating improving the manufacturing efficiency of the first frame 21 and the second frame 22.

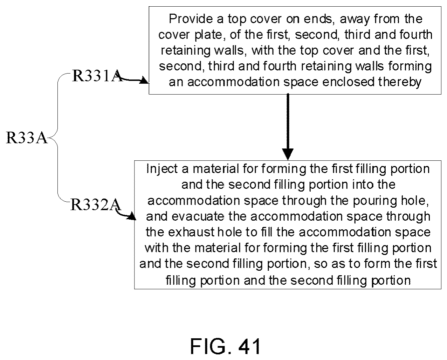

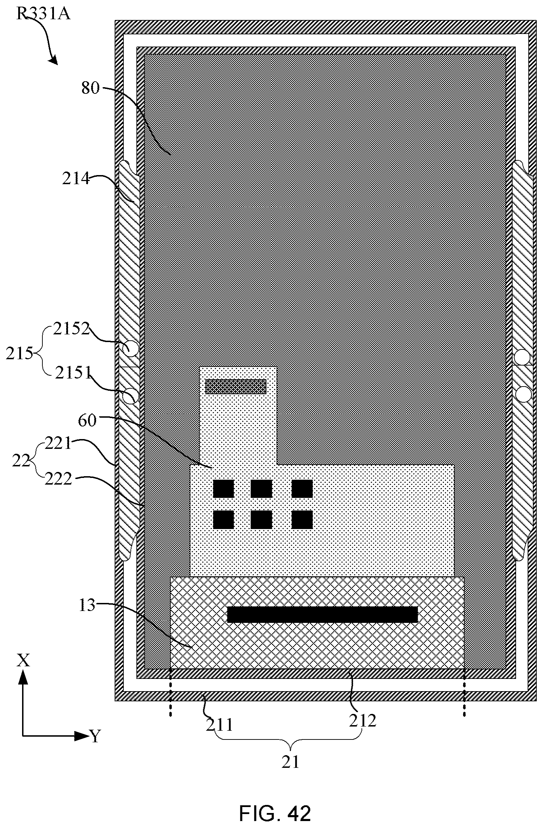

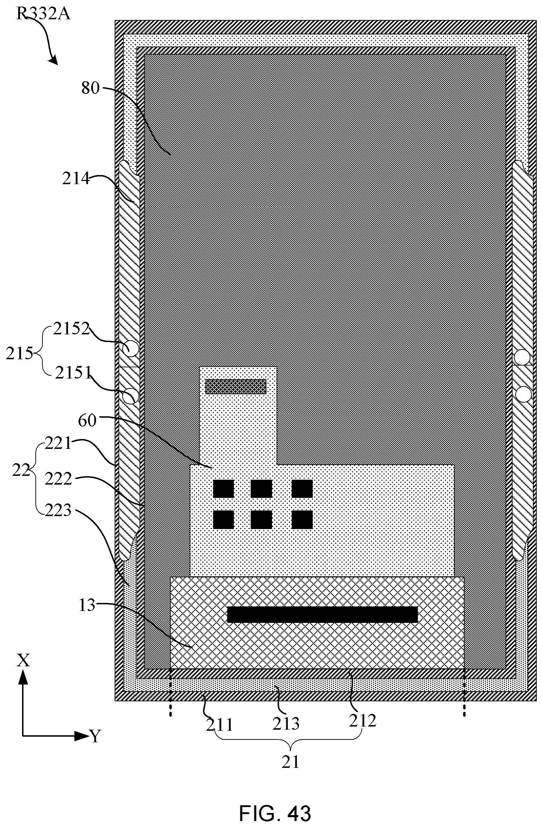

In some embodiments, step R33A after step R32A includes steps R331A and R332A. As shown in FIGS. 41, 42 and 43, FIG. 41 is a flowchart of step R33A of forming the first frame 21 and the second frame 22 synchronously in the method for manufacturing the display module 100 in some embodiments of the present disclosure, and FIGS. 42 and 43 are each a structural diagram corresponding to respective steps of step R33A of forming the first frame 21 and the second frame 22 synchronously in the method for manufacturing the display module 100 in accordance with FIG. 41.

It will be noted that the dashed lines extending in the X direction in FIGS. 42 and 43 refers to the demarcation lines between the first frame 21 and the second frame 22.

In step R331A, as shown in FIG. 42, a top cover 214 is provided on ends, away from the cover plate 30, of the first retaining wall 211, the second retaining wall 212, the third retaining wall 221, and the fourth retaining wall 222, with the top cover 214, the first retaining wall 211, the second retaining wall 212, the third retaining wall 221, and the fourth retaining wall 222 forming an accommodation space enclosed thereby. Here, the top cover 214 is provided therein with a plurality of through holes 215, in which the through holes 215 include at least one pouring hole 2151 and at least one exhaust hole 2152, that is, the top cover 214 is provided therein with both the pouring hole 2151 and the exhaust hole 2152.

In step R332A, as shown in FIG. 43, a material for forming the first filling portion 213 and the second filling portion 223 is injected into the accommodation space through the pouring hole 2151, and the accommodation space is evacuated through the exhaust hole 2152 to fill the accommodation space with the material for forming the first filling portion 213 and the second filling portion 223, so as to form the first filling portion 213 and the second filling portion 223.

It will be noted that the structure and method for manufacturing the top cover 214 in these embodiments are substantially the same as those of the top cover 214 described in the foregoing, and will not be repeated herein.

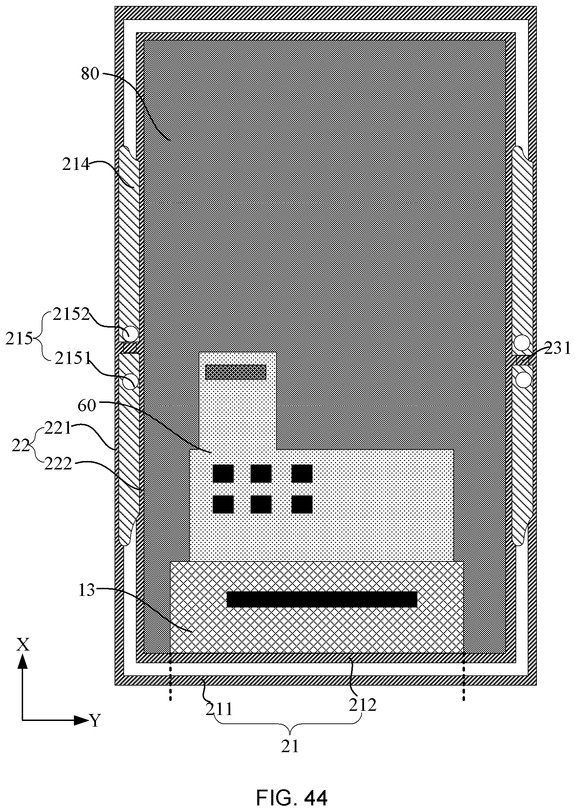

In some embodiments, as shown in FIG. 44, the method for manufacturing the display module 100 further includes forming a fifth retaining wall 231 by a printing process, where the fifth retaining wall 231 is printed within the accommodation space enclosed by the top cover 214, the first retaining wall 211, the second retaining wall 212, the third retaining wall 221, and the fourth retaining wall 222, dividing the accommodation space into a plurality of accommodation sub-spaces. Each of the accommodation sub-spaces may have the first filling portion 213 and/or the second filling portion 223 formed therein, thereby shortening the flow path of the pouring of the adhesive material and promoting the adhesive material to fully fill each of the accommodation sub-spaces, which is conducive to improving the yield of the first frame 21 and the second frame 22.

For example, the fifth retaining wall 231 may be formed synchronously with the first retaining wall 211, the second retaining wall 212, the third retaining wall 221 or the fourth retaining wall 222, which is conducive to simplifying the manufacturing process and improving the manufacturing efficiency.

The foregoing description is only specific embodiments of the present disclosure, but the scope of protection of the present disclosure is not limited thereto. Any changes or replacements that a person skilled in the art could conceive of within the technical scope of the present disclosure shall be included in the protection scope of the present disclosure. Therefore, the protection scope of the present disclosure shall be subject to the protection scope of the claims.

## Claims

1. A display module, comprising:
a display panel, comprising a display portion, a bending portion and a bonding portion that are connected to each other in sequence, the bending portion being bent to enable the bonding portion to be located on a non-display side of the display portion;
a cover plate, provided on a display side of the display portion in a stack, wherein a boundary of the cover plate is farther away from the display portion than a boundary of the bending portion farthest from the display portion; and
a first frame, provided on a side of the cover plate proximate to the display panel and extending along a side edge of the cover plate corresponding to the bonding portion;
wherein the first frame comprises:
a first retaining wall and a second retaining wall, wherein an end of the first retaining wall is connected to an edge region of the cover plate, an end of the second retaining wall is connected to the bonding portion, and the first retaining wall and the second retaining wall have a spacing therebetween; and
a first filling portion, provided between the first retaining wall and the second retaining wall in a filling manner;
wherein a viscosity of a material for forming the first retaining wall and a viscosity of a material for forming the second retaining wall are greater than a viscosity of a material for forming the first filling portion.

2. The display module according to claim 1, further comprising a top cover, the top cover being connected to ends, away from the cover plate, of the first retaining wall and the second retaining wall; wherein
the top cover, the first retaining wall and the second retaining wall form an accommodation space enclosed thereby, and the accommodation space is filled with the first filling portion; and
the top cover is provided therein with a plurality of through holes.

3. The display module according to claim 2, wherein the top cover comprises a support layer and a body layer that are arranged in a stack, the support layer being closer to the cover plate than the body layer.

4. The display module according to claim 3, wherein the support layer comprises a metal mesh, and edges of the body layer are connected to the first retaining wall and the second retaining wall through mesh holes of the metal mesh.

5. The display module according to claim 3 or 4, wherein a material of the body layer is the same as the material of the first retaining wall.

6. The display module according to any one of claims 2 to 5, wherein a width of a portion of the top cover provided with the through holes is greater than a width of a portion not provided with the through holes.

7. The display module according to any one of claims 2 to 6, wherein the ends, away from the cover plate, of the first retaining wall and the second retaining wall are each provided with a notch, and edges of the top cover are placed within notches of the first retaining wall and the second retaining wall.

8. The display module according to claim 1, wherein the first filling portion is provided therein with magnetic particles or conductive particles.

9. The display module according to claim 8, wherein the magnetic particles comprise at least one type of magnetic nanoparticles or magnetic polymer particles; and
the conductive particles comprise at least one type of organic conductive particles or carbon conductive particles.

10. The display module according to claim 8 or 9, further comprising an ink layer, provided on the side of the cover plate proximate to the display panel and located on the edge region of the cover plate; wherein
the first filling portion is in contact with the ink layer, and a portion of the first filling portion extends between the bending portion and the ink layer.

11. The display module according to claim 10, wherein the ink layer has magnetism.

12. The display module according to any one of claims 8 to 11, wherein the bending portion is bent to form a cavity facing the display portion; and the display module further comprises a third filling portion provided in the cavity formed by the bending portion in a filling manner, a material of the third filling portion being different from the material of the first filling portion.

13. The display module according to any one of claims 1 to 12, further comprising a second frame, the first frame being connected to the second frame to form a box-frame surrounding the display panel; wherein
a width of the second frame is substantially equal to a width of the first retaining wall or the second retaining wall, and a viscosity of a material for forming the second frame is greater than the viscosity of the material for forming the first filling portion.

14. The display module according to claim 13, wherein a width of the first frame is greater than the width of the second frame.

15. The display module according to any one of claims 1 to 12, further comprising a second frame, the first frame being connected to the second frame to form a box-frame surrounding the display panel;
wherein the second frame comprises:
a third retaining wall and a fourth retaining wall, wherein an end of the third retaining wall is connected to the edge region of the cover plate, an end of the fourth retaining wall is connected to the display portion, and the third retaining wall and the fourth retaining wall have a spacing therebetween; and
a second filling portion, provided between the third retaining wall and the fourth retaining wall in a filling manner;
wherein a viscosity of a material for forming the third retaining wall and a viscosity of a material for forming the fourth retaining wall are greater than a viscosity of a material for forming the second filling portion.

16. The display module according to claim 15, wherein the display module comprises a top cover, the top cover being connected to ends, away from the cover plate, of the first retaining wall, the second retaining wall, the third retaining wall, and the fourth retaining wall; wherein
the top cover, the first retaining wall, the second retaining wall, the third retaining wall, and the fourth retaining wall form an accommodation space enclosed thereby, and the accommodation space is filled with the first filling portion and the second filling portion; and
the top cover is provided therein with a plurality of through holes.

17. The display module according to claim 16, further comprising at least one fifth retaining wall, the fifth retaining wall being provided in the accommodation space to divide the accommodation space into a plurality of accommodation sub-spaces; wherein
a region, corresponding to each of the accommodation sub-spaces, of the top cover is provided therein with multiple ones of the plurality of through holes.

18. The display module according to any one of claims 1, and 8 to 15, wherein the first retaining wall, the second retaining wall and the first filling portion are formed as a one-piece structure, and a surface of the first filling portion away from the cover plate is recessed in a direction proximate to the cover plate.

19. The display module according to any one of claims 3 to 5, wherein the first retaining wall, the second retaining wall, the first filling portion, and the body layer of the top cover are formed as a one-piece structure, and the support layer of the top cover is embedded in the one-piece structure.

20. A method for manufacturing a display module, comprising:
providing a display panel, the display panel comprising a display portion, a bending portion and a bonding portion that are connected to each other in sequence, and bending the bending portion to enable the bonding portion to be located on a non-display side of the display portion;
providing a cover plate on a display side of the display portion in a stack, wherein a boundary of the cover plate is farther away from the display portion than a boundary of the bending portion farthest from the display portion; and
forming a first frame on a side of the cover plate proximate to the display panel, the first frame extending along a side edge of the cover plate corresponding to the bonding portion;
wherein forming the first frame comprises:
forming a first retaining wall on an edge region of the cover plate by a printing process;
forming a second retaining wall on a side of the bonding portion away from the cover plate by a printing process, the second retaining wall and the first retaining wall having a spacing therebetween; and
forming a first filling portion between the first retaining wall and the second retaining wall by a printing process or an adhesive pouring process;
wherein a viscosity of a material for forming the first retaining wall and a viscosity of a material for forming the second retaining wall are greater than a viscosity of a material for forming the first filling portion.

21. The method for manufacturing the display module according to claim 20, further comprising:
forming a top cover, the top cover being connected to ends, away from the cover plate, of the first retaining wall and the second retaining wall, to enable the top cover, the first retaining wall and the second retaining wall to form an accommodation space enclosed thereby, wherein the top cover is provided therein with a plurality of through holes, and the plurality of through holes comprise at least one pouring hole and at least one exhaust hole; and
injecting an adhesive material into the accommodation space through the pouring hole by an adhesive pouring process, and evacuating the accommodation space through the exhaust hole to enable the adhesive material to fill the accommodation space to form the first filling portion.

22. The method for manufacturing the display module according to claim 21, wherein forming the top cover comprises:
forming a support layer on the ends, away from the cover plate, of the first retaining wall and the second retaining wall; and
forming a body layer on a side of the support layer away from the cover plate by a printing process.

23. The method for manufacturing the display module according to claim 20, wherein forming the first filling portion comprises:
putting an adhesive material containing conductive particles or magnetic particles between the first retaining wall and the second retaining wall; and
applying an electric field force or a magnetic field force to the display module to enable the adhesive material containing the conductive particles or the magnetic particles to flow toward a side proximate to the cover plate, and flow to a space between the cover plate and the bending portion.

24. The method for manufacturing the display module according to claim 20, wherein forming the first filling portion comprises:
forming a magnetic ink layer on the edge region of the cover plate on a side thereof proximate to the display panel; and
putting an adhesive material containing magnetic particles between the first retaining wall and the second retaining wall, to enable the magnetic particles within the adhesive material containing the magnetic particles to flow toward a direction proximate to the magnetic ink layer due to a magnetic field force of the magnetic ink layer, and flow to a space between the cover plate and the bending portion.

25. The method for manufacturing the display module according to any one of claims 20 to 24, further comprising:
forming a second frame on the side of the cover plate proximate to the display panel, the second frame being connected to the first frame to form a box-frame surrounding the display panel;
wherein the second frame is formed synchronously with the first retaining wall, or the second frame is formed synchronously with the second retaining wall.

26. The method for manufacturing the display module according to any one of claims 20 to 24, further comprising:
forming a second frame on the side of the cover plate proximate to the display panel, the second frame being connected to the first frame to form a box-frame surrounding the display panel;
wherein forming the second frame comprises:
forming a third retaining wall on the edge region of the cover plate by a printing process, the third retaining wall being formed synchronously with the first retaining wall;
forming a fourth retaining wall on a side of the display portion away from the cover plate by a printing process, the fourth retaining wall being formed synchronously with the second retaining wall, and the fourth retaining wall and the third retaining wall having a spacing therebetween; and
forming a second filling portion between the third retaining wall and the fourth retaining wall by a printing process or an adhesive pouring process.

27. The method for manufacturing the display module according to any one of claims 20 to 26, further comprising, before bending the bending portion to enable the bonding portion to be located on the non-display side of the display portion:
forming a third filling portion on a side of the bending portion.

28. A display apparatus, comprising:
the display module according to any one of claims 1 to 19; and
a middle frame, provided around the display module;
wherein a distance between the first frame of the display module and a side wall of the middle frame proximate to the display module ranges from 0 to 0.5 mm.

29. The display apparatus according to claim 28, wherein the middle frame comprises a first portion and a second portion, the first portion being provided around the display module, the second portion being connected to an end of the first portion away from the cover plate, and the second portion comprising a first surface facing the cover plate; and
a surface of the first frame away from the cover plate is in contact with the first surface.
